# EUROPEAN PATENT APPLICATION

(11) **EP 4 739 054 A1**
(43) Date of publication of application: **06.05.2026**
(21) Application number: 25198984.4
(22) Date of filing: 29.08.2025
(51) Int. Cl.: H10K 59/131, H10K 59/121, H10K 59/124, H10K 59/65

(54) **DISPLAY DEVICE**

(30) Priority: 29.10.2024 KR 20240150014
(71) Applicant: LG Display Co., Ltd., Seoul, 07336 (KR)
(72) Inventor: KIM, Taehwi, 10845 Paju-si, Gyeonggi-do (KR); NA, SeHwan, 10845 Paju-si, Gyeonggi-do (KR); AHN, Soonsung, 10845 Paju-si, Gyeonggi-do (KR)
(74) Representative: Viering, Jentschura & Partner mbB Patent- und Rechtsanwälte

(57) **Abstract**

The embodiments of the present disclosure relate to a display device (100), and more particularly, to a display device (100) capable of minimizing luminance variation caused by differences in wiring resistance within an optical area (OA) by differentially arranging a plurality of data connection lines (DCL1, DCL2), including a first connection line (DCL1) and a second connection line (DCL2) having a lower resistance than the first connection line (DCL1), in the optical area (OA).

## Description

### TECHNICAL FIELD

The present disclosure relates to a display device.

### BACKGROUND

With advancements in technology, display devices may provide not only image display functions but also camera functions and various sensing capabilities. To achieve this, display devices are required to be equipped with optoelectronic devices such as cameras and sensing sensors (also referred to as light-receiving devices or sensors).

Since optoelectronic devices need to receive light from the front of the display device, they must be installed in locations that facilitate light reception. Accordingly, conventional designs have required cameras (camera lenses) and sensing sensors to be exposed on the front of the display device. As a result, the bezel of the display panel becomes wider, or optoelectronic devices are positioned in areas where a notch or a physical hole is formed within the display area of the display panel.

In other words, as optoelectronic devices such as cameras and sensing sensors, which receive light from the front to perform their designated functions, are incorporated into display devices, the bezel on the front of the display device may become larger, or design constraints may arise for the front of the display device. Additionally, when a display device includes optoelectronic devices, the structural configuration accommodating these devices may lead to unintended degradation in image quality.

### SUMMARY

The embodiments of the present disclosure may provide a display device in which an optoelectronic device is not exposed on the front of the display device, while still allowing the optoelectronic device, disposed below the display panel, to properly receive light through a light-transmitting structure.

The embodiments of the present disclosure may provide a display device that enables a high transmittance optical area through differential design of data connection lines while minimizing luminance variation caused by differences in line resistance within the optical area.

The embodiments of the present disclosure may provide a display device that ensures luminance uniformity through differential design of data connection lines, thereby improving optical characteristics and yield while enabling low-power operation.

The embodiments of the present disclosure may provide a display device that minimizes luminance variation by optimizing the design of the material, thickness, and wiring length of data connection lines. Embodiments of the present disclosure may provide a display device according to claim 1. Further embodiments are described in the dependent claims.

The embodiments of the present disclosure may provide a display device comprising: a display panel comprising an optical area having a plurality of transmissive areas and a plurality of first emission areas, a general area disposed outside the optical area and having a plurality of second emission areas, and a plurality of data connection lines disposed in a first direction in at least one of the plurality of transmissive areas; and an optoelectronic device disposed below the display panel and overlapping the optical area. The plurality of data connection lines includes at least one first connection line disposed in a first area and a second area of the optical area, and at least one second connection line disposed in the first area and having a lower resistance than the first connection line.

The embodiments of the present disclosure may provide a display device comprising: a substrate including a plurality of transmissive areas and a plurality of emission areas; a transistor layer disposed on the substrate and including at least one transistor and a plurality of interlayer insulating films; a plurality of planarization layers disposed on the transistor layer; and a light-emitting device layer including a plurality of data sub-lines, which are disposed on any one of the plurality of planarization layers in the plurality of emission areas and electrically connected to at least one of a first connection line and at least one of a second connection line, and a plurality of light-emitting devices, which are disposed on the plurality of planarization layers and correspond to each of the plurality of emission areas.

According to the embodiments of the present disclosure, a display device may be provided in which an optoelectronic device is not exposed on the front of the display device, while still allowing the optoelectronic device, disposed below the display panel, to properly receive light through a light-transmitting structure.

According to the embodiments of the present disclosure, a display device may be provided that enables a high transmittance optical area through differential design of data connection lines while minimizing luminance variation caused by differences in line resistance within the optical area.

According to the embodiments of the present disclosure, a display device may be provided that ensures luminance uniformity through differential design of data connection lines, thereby improving optical characteristics and yield while enabling low-power operation.

According to the embodiments of the present disclosure, a display device may be provided that minimizes luminance variation by optimizing the design of the material, thickness, and wiring length of data connection lines.

### BRIEF DESCRIPTION OF THE DRAWINGS

FIG. 1A to FIG. 1E are diagrams for illustrating a display device according to embodiments of the present disclosure.
FIG. 2 is a diagram for illustrating a system configuration of a display device according to embodiments of the present disclosure.
FIG. 3 is a diagram for illustrating an example of a sub-pixel according to embodiments of the present disclosure.
FIG. 4 is a diagram for illustrating an arrangement of sub-pixels in a general area and an optical area according to embodiments of the present disclosure.
FIG. 5A and FIG. 5B are diagrams for illustrating an arrangement of signal lines in a display panel according to embodiments of the present disclosure.
FIG. 6 and FIG. 7 are diagrams for illustrating an optical area according to embodiments of the present disclosure.
FIG. 8 to FIG. 13 are diagrams for illustrating various combinations of a first connection line and a second connection line in a display device, according to embodiments of the present disclosure.
FIG. 14 to FIG. 18 are diagrams for illustrating implementation examples of a display device according to embodiments of the present disclosure.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe non-consecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, various embodiments of the present disclosure will be described in detail with reference to the accompanying drawings.

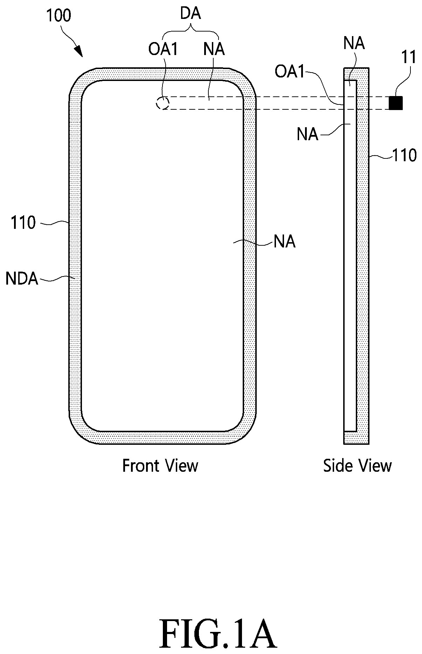

FIG. 1A to FIG. 1E are diagrams for illustrating a display device 100 according to embodiments of the present disclosure.

Referring to FIG. 1A to FIG. 1E, a display device 100 according to embodiments of the present disclosure may include a display panel 110 for displaying an image and at least one optoelectronic device 11 and/or 12.

The display panel 110 may include a display area DA where an image is displayed and a non-display area NDA where an image is not displayed.

A plurality of sub-pixels may be arranged in the display area DA, and various signal lines for driving the plurality of sub-pixels may be arranged.

The non-display area NDA may be an outer area of the display area DA. Various signal lines may be arranged in the non-display area NDA, and various driving circuits may be connected thereto. The non-display area NDA may be bent so as not to be visible from the front or may be covered by a case (not shown). The non-display area NDA is also referred to as a bezel or a bezel area.

Referring to FIG. 1A to FIG. 1D, the at least one optoelectronic device 11 and/or 12 in the display device 100 according to embodiments of the present disclosure may be an electronic component positioned on the lower part of the display panel 110 (i.e., on the opposite side of the viewing surface).

External light may enter through the front surface (viewing surface) of the display panel 110, pass through the display panel 110, and be transmitted to the at least one optoelectronic device 11 and/or 12 positioned below the display panel 110.

The at least one optoelectronic device 11 and/or 12 may receive external light transmitted through the display panel 110 and perform a predetermined function according to the received external light. For example, the at least one optoelectronic device 11 and/or 12 may include at least one of an imaging device such as a camera (image sensor), a proximity sensor, and an ambient light sensor.

Referring to FIG. 1A to FIG. 1E, in the display panel 110 according to embodiments of the present disclosure, the display area DA may include a general area NA and at least one optical area OA1 and/or OA2, wherein the general area NA is disposed outside the at least one optical area OA1 and/or OA2.

The at least one optical area OA1 and/or OA2 may be an area that overlaps with the at least one optoelectronic device 11 and/or 12, respectively.

According to the example of FIG. 1A, the display area DA may include a general area NA and a first optical area OA1. Here, at least a portion of the first optical area OA1 may overlap with the first optoelectronic device 11.

In FIG. 1A, the first optical area OA1 is illustrated as having a circular shape; however, the shape of the first optical area OA1 according to the embodiments of the present disclosure is not limited thereto.

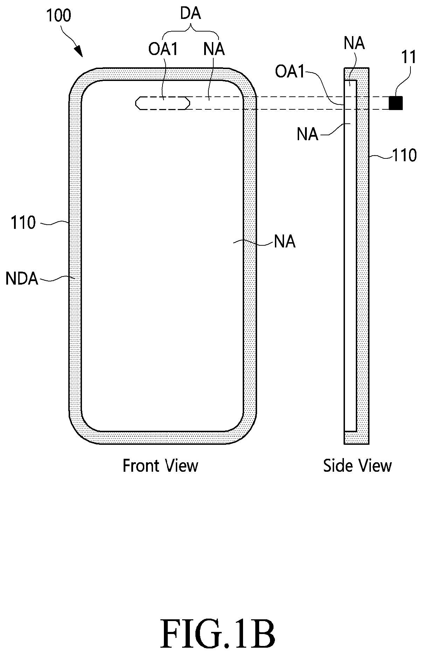

For example, as shown in FIG. 1B, the first optical area OA1 may have an octagonal shape, and in addition, it may have various polygonal shapes.

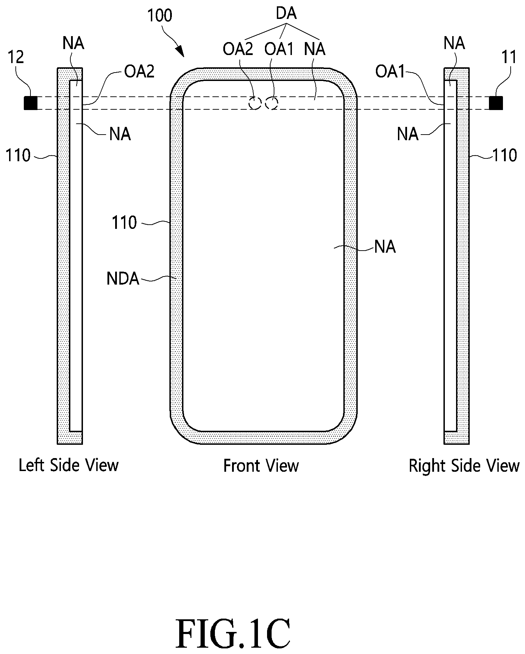

According to the example of FIG. 1C, the display area DA may include a general area NA, a first optical area OA1, and a second optical area OA2. In the example of FIG. 1C, a general area NA may be disposed between the first optical area OA1 and the second optical area OA2. Here, at least a portion of the first optical area OA1 may overlap with the first optoelectronic device 11, and at least a portion of the second optical area OA2 may overlap with the second optoelectronic device 12.

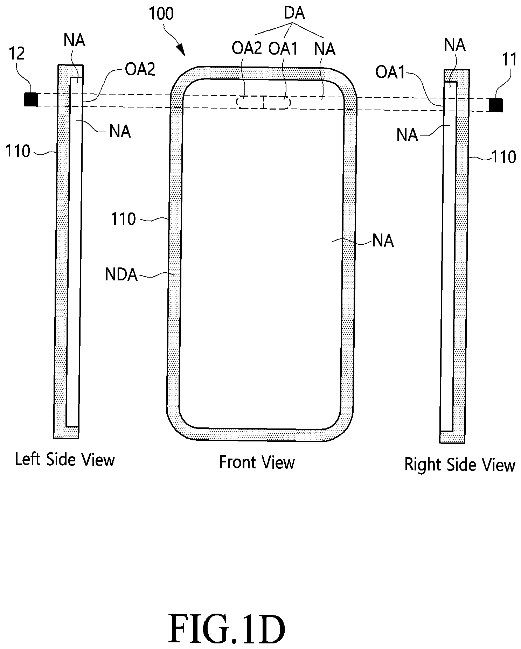

According to the example of FIG. 1D, the display area DA may include a general area NA, a first optical area OA1, and a second optical area OA2. In the example of FIG. 1D, no general area NA may be disposed between the first optical area OA1 and the second optical area OA2. That is, the first optical area OA1 and the second optical area OA2 may be in contact with each other. Here, at least a portion of the first optical area OA1 may overlap with the first optoelectronic device 11, and at least a portion of the second optical area OA2 may overlap with the second optoelectronic device 12.

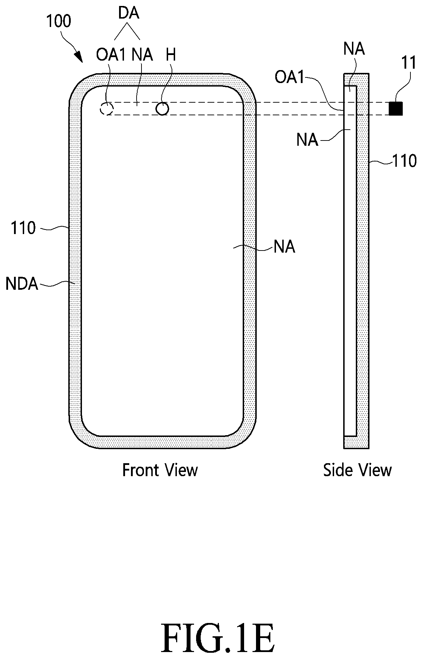

According to the example of FIG. 1E, the display panel 110 further includes a hole area H, in which the second optoelectronic device 12 is disposed and which is surrounded by the general area NA. In the hole area H, the second optoelectronic device 12 may be positioned above the display panel 110. However, the embodiments of the present disclosure are not limited thereto, and the hole area H may be a second optical area OA2 in which the second optoelectronic device 12 is positioned below the display panel 110 within the display area DA.

The display area DA on the display panel 110 may include the first optical area OA1 and the general area NA.

According to the example of FIG. 1E, a general area NA is disposed between the first optical area OA1 and the hole area H, and the hole area H is disposed on an imaginary centerline that vertically divides the display panel 110. The first optical area OA1 may be spaced apart from the hole area H to the left or right with respect to the imaginary centerline.

In FIG. 1E, the first optical area OA1 and the hole area H are illustrated as having the same size; however, the present disclosure is not limited thereto. For example, the sizes of the first optical area OA1 and the hole area H may be different. For instance, the size of the first optical area OA1 may be smaller than the size of the hole area H.

The at least one optical area OA1 and/or OA2 may include both an image display structure and a light-transmitting structure. That is, since the at least one optical area OA1 and/or OA2 is a part of the display area DA, sub-pixels for image display must be arranged in the at least one optical area OA1 and/or OA2. In addition, the at least one optical area OA1 and/or OA2 must include a light-transmitting structure for allowing light to pass through to the at least one optoelectronic device 11 and/or 12.

Hereinafter, the image display structure may be referred to as an emission area, and the light-transmitting structure may be referred to as a transmissive area.

The at least one optoelectronic device 11 and/or 12 is a device that requires light reception; however, it is positioned on the lower part of the display panel 110 (on the opposite side of the viewing surface) and receives light transmitted through the display panel 110.

The least one optoelectronic device 11 and/or 12 is not exposed on the front surface (viewing surface) of the display panel 110. Accordingly, when a user looks at the front of the display device 100, the optoelectronic device 11 and/or 12 may not be visible to the user.

For example, the first optoelectronic device 11 may be a sensing sensor such as a proximity sensor or an ambient light sensor, and the second optoelectronic device 12 may be a camera. For example, the sensing sensor may be an infrared sensor that detects infrared rays.

Conversely, the first optoelectronic device 11 may be a camera, and the second optoelectronic device 12 may be a sensing sensor.

Hereinafter, for convenience of explanation, an example will be described in which the first optoelectronic device 11 is a sensing sensor, and the second optoelectronic device 12 is a camera. Here, the camera may refer to a camera lens or an image sensor.

When the second optoelectronic device 12 is a camera, the camera is positioned below the display panel 110 but may be a front camera that captures images in the front direction of the display panel 110. Accordingly, a user may take pictures using the camera, which is not visible on the viewing surface while looking at the viewing surface of the display panel 110.

The general area NA and the at least one optical area OA1 and/or OA2 are display areas DA capable of displaying images. However, the general area NA is an area where a light-transmitting structure does not need to be formed, whereas the at least one optical area OA1 and/or OA2 is an area where a light-transmitting structure must be formed.

Accordingly, the at least one optical area OA1 and/or OA2 is required to have a transmittance above a certain level, whereas the general area NA may have no light transmittance or may have a low transmittance below a certain level.

For example, the at least one optical area OA1 and/or OA2 and the general area NA may differ in resolution, sub-pixel arrangement structure, the number of sub-pixels per unit area, electrode structure, wiring structure, electrode arrangement structure, or wiring arrangement structure.

For example, the number of sub-pixels per unit area in the at least one optical area OA1 and/or OA2 may be smaller than that in the general area NA. That is, the resolution of the at least one optical area OA1 and/or OA2 may be lower than that of the general area NA. Here, the number of sub-pixels per unit area is a unit for measuring resolution and may also be referred to as PPI (Pixels Per Inch), which indicates the number of pixels per inch.

For example, the number of sub-pixels per unit area in the first optical area OA1 may be smaller than that in the general area NA. The number of sub-pixels per unit area in the second optical area OA2 may be equal to or greater than that in the first optical area OA1.

Each of the first optical area OA1 and the second optical area OA2 may have various shapes such as a circle, an ellipse, a rectangle, a hexagon, or an octagon. The first optical area OA1 and the second optical area OA2 may have the same shape or different shapes.

Referring to FIG. 1C, when the first optical area OA1 and the second optical area OA2 are in contact with each other, the entire optical area, including the first optical area OA1 and the second optical area OA2, may also have various shapes such as a circle, an ellipse, a rectangle, a hexagon, or an octagon.

Hereinafter, for convenience of explanation, an example will be described in which each of the first optical area OA1 and the second optical area OA2 is circular.

Since the display device 100 according to embodiments of the present disclosure does not require a notch or hole in the display panel 110 for exposing a camera or a sensing sensor, the area of the display area DA may not be reduced.

Accordingly, since the display panel 110 does not require a notch or camera hole for exposing a camera or a sensing sensor, the size of the bezel area may be reduced, and design constraints may be eliminated, thereby increasing the degree of freedom in design.

Even though the at least one optoelectronic device 11 and/or 12 in the display device 100 according to embodiments of the present disclosure is hidden behind the display panel 110, the at least one optoelectronic device 11 and/or 12 must be able to properly receive light and perform its designated function normally.

Additionally, even though the at least one optoelectronic device 11 and/or 12 is hidden behind the display panel 110 and overlaps the display area DA in the display device 100 according to embodiments of the present disclosure, normal image display must be possible in the at least one optical area OA1 and/or OA2, which overlaps the at least one optoelectronic device 11 and/or 12 within the display area DA.

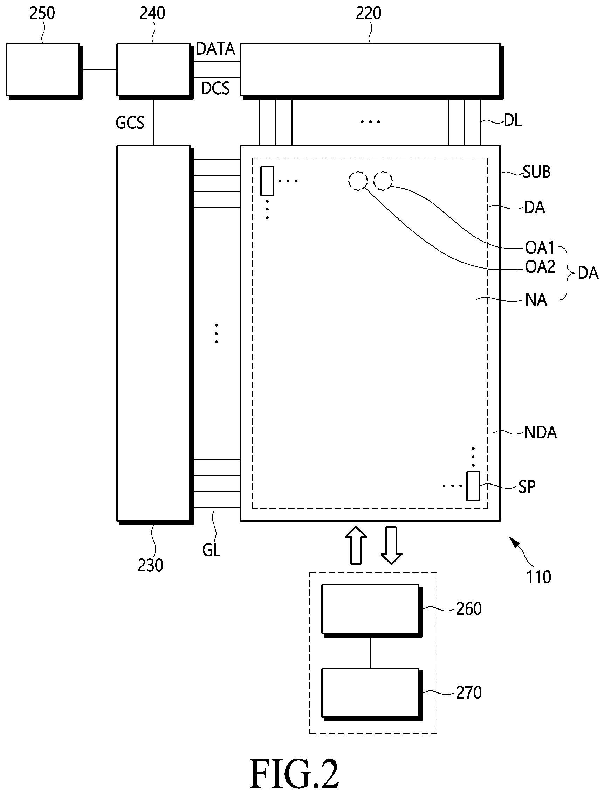

FIG. 2 is a diagram for illustrating the system configuration of a display device 100 according to embodiments of the present disclosure.

Referring to FIG. 2, the display device 100 may include a display panel 110 and a display driving circuit as components for image display.

The display driving circuit is a circuit for driving the display panel 110 and may include a data driving circuit 220, a gate driving circuit 230, and a controller 240.

The display panel 110 may include a display area DA, where an image is displayed, and a non-display area NDA, where an image is not displayed. The non-display area NDA may be an outer area of the display area DA and may also be referred to as a bezel area. The whole or part of the non-display area NDA may be an area visible from the front of the display device 100 or may be bent so as not to be visible from the front of the display device 100.

The display panel 110 may include a substrate SUB and a plurality of sub-pixels SP arranged on the substrate SUB. Additionally, the display panel 110 may further include various types of signal lines for driving the plurality of sub-pixels SP.

The display device 100 according to embodiments of the present disclosure may be a liquid crystal display (LCD) or a self-emissive display in which the display panel 110 emits light by itself. When the display device 100 is a self-emissive display, each of the plurality of sub-pixels SP may include a light-emitting device.

For example, the display device 100 according to embodiments of the present disclosure may be an organic light-emitting display in which the light-emitting device is implemented as an organic light-emitting diode (OLED). In another example, the display device 100 may be an inorganic light-emitting display in which the light-emitting device is implemented as an inorganic light-emitting diode. In yet another example, the display device 100 may be a quantum dot display in which the light-emitting device is implemented as a quantum dot, which is a semiconductor crystal that emits light by itself.

The structure of each of the plurality of sub-pixels SP may vary depending on the type of the display device 100. For example, when the display device 100 is a self-emissive display in which each sub-pixel SP emits light by itself, each sub-pixel SP may include a self-light-emitting device, at least one transistor, and at least one capacitor.

For example, various types of signal lines may include a plurality of data lines DL for transmitting data signals (also referred to as data voltages or image signals) and a plurality of gate lines GL for transmitting gate signals (also referred to as scan signals SCAN).

The plurality of data lines DL and the plurality of gate lines GL may intersect with each other. Each of the plurality of data lines DL may extend in a first direction, and each of the plurality of gate lines GL may extend in a second direction.

Here, the first direction may be a column direction, and the second direction may be a row direction. Alternatively, the first direction may be a row direction, and the second direction may be a column direction.

Hereinafter, for convenience of explanation, an example will be described in which the first direction is the column direction and the second direction is the row direction.

At least one of the plurality of data lines DL that overlaps the at least one optical area OA1 and/or OA2 may include at least one of a data connection line (a first connection line DCL1 or a second connection line DCL2) and a data sub-line.

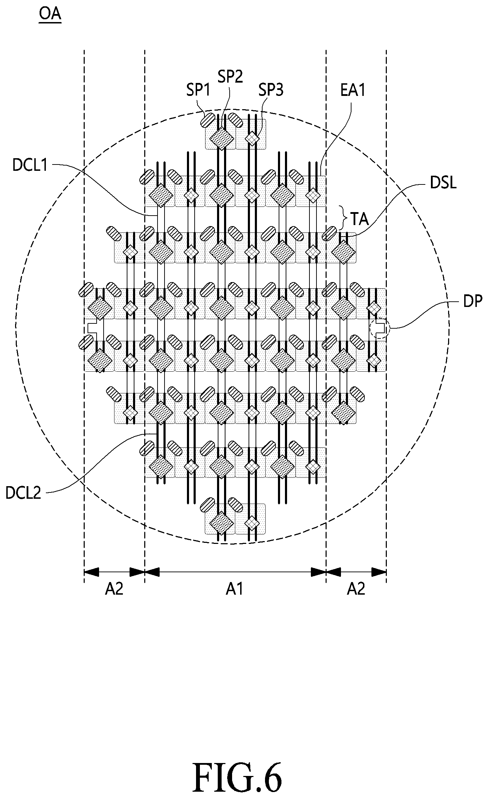

The data connection lines (the first connection line DCL1 and the second connection line DCL2) and data sub-lines will be described in more detail with reference to the embodiments shown in FIG. 6 to FIG. 18.

The data driving circuit 220 is a circuit for driving the plurality of data lines DL and may output data signals to the plurality of data lines DL. The gate driving circuit 230 is a circuit for driving the plurality of gate lines GL and may output gate signals (i.e., scan signals SCAN) to the plurality of gate lines GL.

The controller 240 is a device for controlling the data driving circuit 220 and the gate driving circuit 230 and may control the driving timing of the plurality of data lines DL and the plurality of gate lines GL.

The controller 240 may supply a data driving control signal DCS to the data driving circuit 220 to control it and may supply a gate driving control signal GCS to the gate driving circuit 230 to control it.

The controller 240 may receive input image data from a host system 250 and supply digital image data DATA to the data driving circuit 220 based on the input image data.

The data driving circuit 220 may supply data signals to the plurality of data lines DL according to the driving timing control of the controller 240.

The data driving circuit 220 may receive digital image data DATA from the controller 240, convert the received digital image data DATA into analog data signals, and output the analog data signals to the plurality of data lines DL.

The gate driving circuit 230 may supply gate signals (i.e., scan signals SCAN) to the plurality of gate lines GL according to the timing control of the controller 240. The gate driving circuit 230 may receive, together with various gate driving control signals GCS, a first gate voltage corresponding to a turn-on level voltage, and a second gate voltage corresponding to a turn-off level voltage, generate gate signals, and supply the generated gate signals to the plurality of gate lines GL.

For example, the data driving circuit 220 may be connected to the display panel 110 using a Tape Automated Bonding (TAB) method, may be connected to a bonding pad of the display panel 110 using a Chip On Glass (COG) or Chip On Panel (COP) method, or may be implemented using a Chip On Film (COF) method and connected to the display panel 110.

The gate driving circuit 230 may be connected to the display panel 110 using a Tape Automated Bonding (TAB) method, may be connected to a bonding pad of the display panel 110 using a Chip On Glass (COG) or Chip On Panel (COP) method, or may be connected to the display panel 110 using a Chip On Film (COF) method. Alternatively, the gate driving circuit 230 may be formed in the non-display area NDA of the display panel 110 as a Gate In Panel (GIP) type. The gate driving circuit 230 may be arranged on a substrate SUB or connected to a substrate SUB. That is, when the gate driving circuit 230 is a GIP type, it may be arranged in the non-display area NDA of the substrate SUB. When the gate driving circuit 230 is a COG type or COF type, it may be connected to the substrate SUB.

Meanwhile, at least one of the data driving circuit 220 and the gate driving circuit 230 may be arranged in the display area DA of the display panel 110. For example, at least one of the data driving circuit 220 and the gate driving circuit 230 may be arranged so as not to overlap with the sub-pixels SP, or it may be arranged so that some or all of it overlaps with the sub-pixels SP.

The data driving circuit 220 may be connected to one side of the display panel 110 (e.g., an upper side or a lower side). Depending on the driving method or panel design etc., the data driving circuit 220 may be connected to both sides of the display panel 110 (e.g., both the upper and lower sides) or may be connected to two or more sides among the four sides of the display panel 110.

The gate driving circuit 230 may be connected to one side of the display panel 110 (e.g., a left side or a right side). Depending on the driving method or panel design etc., the gate driving circuit 230 may be connected to both sides of the display panel 110 (e.g., both the left and right sides) or may be connected to two or more sides among the four sides of the display panel 110.

The controller 240 may be implemented as a separate component from the data driving circuit 220 or may be integrated with the data driving circuit 220 as an integrated circuit.

The controller 240 may be a Timing Controller used in conventional display technology, a control device that includes a timing controller and performs additional control functions, a control device different from a timing controller, or a circuit within a control device. The controller 240 may be implemented as various circuits or electronic components such as an Integrated Circuit (IC), a Field Programmable Gate Array (FPGA), an Application Specific Integrated Circuit (ASIC), or a processor.

The controller 240 may be mounted on a Printed Circuit Board (PCB) or a Flexible Printed Circuit (FPC) and may be electrically connected to the data driving circuit 220 and the gate driving circuit 230 through the Printed Circuit Board (PCB) or the Flexible Printed Circuit (FPC).

The controller 240 may transmit and receive signals with the data driving circuit 220 according to at least one predetermined interface. For example, the interface may include LVDS (Low Voltage Differential Signaling), EPI (Embedded Clock Point-to-Point Interface), and SPI (Serial Peripheral Interface).

The display device 100 according to embodiments of the present disclosure may include a touch sensor TS and a touch sensing circuit for providing a touch sensing function in addition to an image display function. The touch sensing circuit may sense the touch sensor TS to detect whether a touch has occurred by a touch object such as a finger or a pen, or to detect the touch position.

The touch sensing circuit may include a touch driving circuit 260 for driving and sensing the touch sensor TS to generate and output touch sensing data and a touch controller 270 for detecting a touch event or detecting a touch position using the touch sensing data.

The touch sensor TS may include a plurality of touch electrodes. The touch sensor TS may further include a plurality of touch lines for electrically connecting the plurality of touch electrodes with the touch driving circuit 260.

The touch sensor TS may exist externally as a touch panel on the display panel 110 or may be integrated inside the display panel 110. When the touch sensor TS exists externally as a touch panel on the display panel 110, it is called an external touch sensor TS. When the touch sensor TS is external, the touch panel and the display panel 110 are separately manufactured and may be combined during the assembly process. An external touch panel may include a substrate SUB for a touch panel and a plurality of touch electrodes on the substrate SUB for a touch panel.

When the touch sensor TS is integrated inside the display panel 110, it may be formed on the substrate SUB during the manufacturing process of the display panel 110, along with the signal lines and electrodes related to display driving.

The touch driving circuit 260 may supply a touch driving signal to at least one of the plurality of touch electrodes and may sense at least one of the plurality of touch electrodes to generate touch sensing data.

The touch sensing circuit may perform touch sensing using either a self-capacitance sensing method or a mutual-capacitance sensing method.

When the touch sensing circuit performs touch sensing using the self-capacitance sensing method, it may perform touch sensing based on the capacitance between each touch electrode and a touch object (e.g., a finger or a pen).

According to the self-capacitance sensing method, each of the plurality of touch electrodes may function as both a driving touch electrode and a sensing touch electrode. The touch driving circuit 260 may drive all or some of the plurality of touch electrodes and may sense all or some of the plurality of touch electrodes.

When the touch sensing circuit performs touch sensing using the mutual-capacitance sensing method, it may perform touch sensing based on the capacitance between touch electrodes.

According to the mutual-capacitance sensing method, the plurality of touch electrodes are divided into driving touch electrodes and sensing touch electrodes. The touch driving circuit 260 may drive the driving touch electrodes and sense the sensing touch electrodes.

The touch driving circuit 260 and the touch controller 270 included in the touch sensing circuit may be implemented as separate devices or as a single device. Additionally, the touch driving circuit 260 and the data driving circuit 220 may be implemented as separate devices or as a single device.

The display device 100 may further include a power supply circuit for supplying various power sources to the display driving circuit and/or the touch sensing circuit.

The display device 100 according to embodiments of the present disclosure may be a mobile terminal such as a smartphone or tablet, or it may be a monitor or television (TV) of various sizes. However, the present disclosure is not limited thereto and may be a display of various types and sizes capable of outputting information or images.

As described above, the display area DA of the display panel 110 may include a general area NA and the at least one optical area OA1 and/or OA2.

The general area NA and the at least one optical area OA1 and/or OA2 are areas capable of image display. However, the general area NA is an area where a light-transmitting structure does not need to be formed, whereas the at least one optical area OA1 and/or OA2 is an area where a light-transmitting structure must be formed.

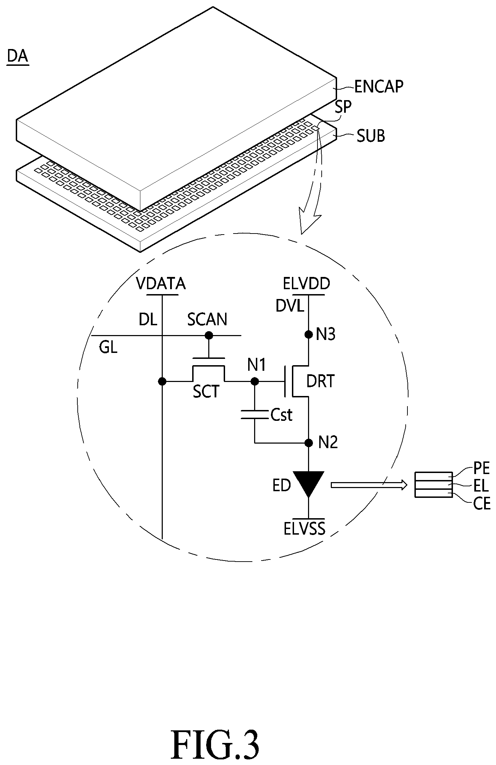

FIG. 3 is a diagram for illustrating an example of a sub-pixel SP according to embodiments of the present disclosure.

Referring to FIG. 3, each of the sub-pixels SP arranged in the general area NA, the first optical area OA1, and the second optical area OA2 included in the display area DA of the display panel 110 may include a light-emitting device ED arranged on the substrate SUB and in the emission area, a driving transistor DRT for driving the light-emitting device ED, a scan transistor SCT for delivering a data voltage VDATA to a first node N1 of the driving transistor DRT, and a storage capacitor Cst for maintaining a constant voltage during one frame.

The driving transistor DRT may include a first node N1 where the data voltage is applied, a second node N2 electrically connected to the light-emitting device ED, and a third node N3 where a driving voltage ELVDD is applied from a driving voltage line DVL.

The first node N1 of the driving transistor DRT may be a gate node of the driving transistor DRT and may be electrically connected to a source node or drain node of the scan transistor SCT.

The second node N2 of the driving transistor DRT may be a source node or drain node of the driving transistor DRT and may be electrically connected to a pixel electrode PE of the light-emitting device ED.

The third node N3 of the driving transistor DRT may be a drain node or source node of the driving transistor DRT.

The storage capacitor Cst may be connected between the first node N1 and the second node N2 of the driving transistor DRT. The storage capacitor Cst charges an amount of charge corresponding to the voltage difference between its two terminals and serves to maintain the voltage difference for a predetermined frame time. Accordingly, the corresponding sub-pixel SP may emit light during the predetermined frame time.

The scan transistor SCT may be controlled by a gate signal (i.e., a scan signal SCAN) and may be connected between the first node N1 of the driving transistor DRT and the data line DL.

The scan transistor SCT may be turned on by a gate signal of a turn-on level voltage supplied from the gate line GL and may deliver the data voltage VDATA supplied from the data line DL to the first node N1 of the driving transistor DRT.

The scan transistor SCT and the driving transistor DRT may be n-type transistors or p-type transistors.

Here, when the scan transistor SCT is an n-type transistor, the turn-on level voltage of the gate signal may be a high-level voltage. When the scan transistor SCT is a p-type transistor, the turn-on level voltage of the gate signal may be a low-level voltage.

The light-emitting device ED may include a pixel electrode PE, an emission layer EL, and a common electrode CE. A base voltage ELVSS may be applied to the common electrode CE.

For example, the pixel electrode PE may be an anode electrode, and the common electrode CE may be a cathode electrode. Conversely, the pixel electrode PE may be a cathode electrode, and the common electrode CE may be an anode electrode. Hereinafter, for convenience of explanation, it is assumed that the pixel electrode PE is an anode electrode and the common electrode CE is a cathode electrode.

For example, the light-emitting device ED may be an organic light-emitting diode (OLED), an inorganic light-emitting diode, or a quantum dot light-emitting device. In this case, when the light-emitting device ED is an organic light-emitting diode, the emission layer EL of the light-emitting device ED may include an organic emission layer containing organic materials.

The storage capacitor Cst may be an external capacitor, which is intentionally designed outside the driving transistor DRT, rather than a parasitic capacitor (e.g., Cgs, Cgd), which is an internal capacitor that exists between the gate node and the source node (or drain node) of the driving transistor DRT.

Since the circuit elements within each sub-pixel SP, particularly the light-emitting device ED, are vulnerable to external moisture and oxygen, an encapsulation layer ENCAP may be arranged in the display panel 110 to prevent moisture or oxygen from penetrating into the circuit elements, particularly the light-emitting device ED. The encapsulation layer ENCAP may be arranged to cover the light-emitting devices ED.

The structure of the sub-pixel SP shown in FIG. 3 is merely an example and may be variously modified to include one or more additional transistors or one or more additional capacitors.

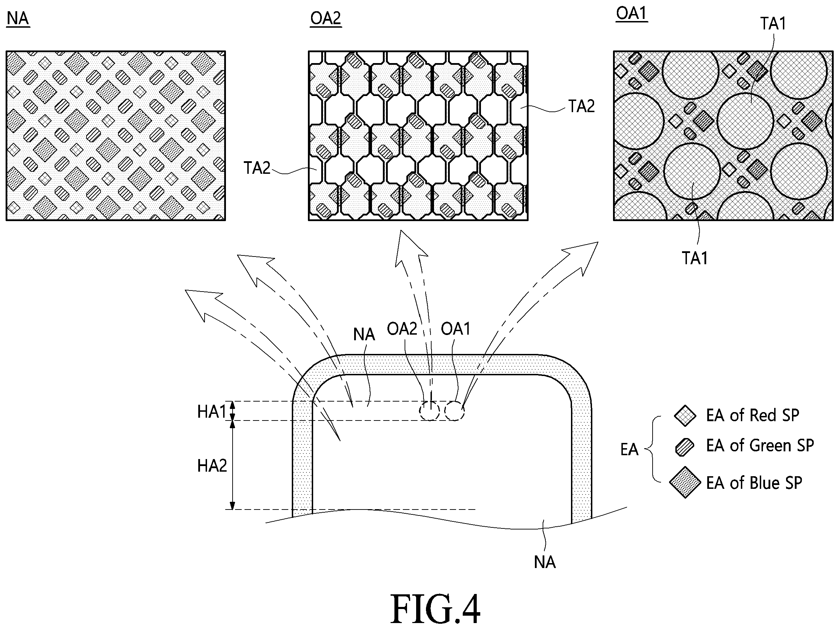

FIG. 4 is a diagram for illustrating the arrangement of sub-pixels SP in the general area NA and the optical areas OA1 and OA2 according to embodiments of the present disclosure.

Referring to FIG. 4, a plurality of sub-pixels SP may be arranged in each of the general area NA, the first optical area OA1, and the second optical area OA2 included in the display area DA.

For example, the plurality of sub-pixels SP may include red sub-pixels (Red SP) that emit red light, green sub-pixels (Green SP) that emit green light, and blue sub-pixels (Blue SP) that emit blue light.

Accordingly, each of the general area NA, the first optical area OA1, and the second optical area OA2 may include a plurality of emission areas EA of red sub-pixels Red SP, a plurality of emission areas EA of green sub-pixels Green SP, and a plurality of emission areas EA of blue sub-pixels Blue SP.

Hereinafter, for convenience of explanation, the emission areas EA included in the first optical area OA1 and the second optical area OA2 may be referred to as first emission areas EA1, and the emission areas EA included in the general area NA may be referred to as second emission areas EA2.

Referring to FIG. 4, the general area NA may include a plurality of emission areas EA but may not include a transmissive area TA (i.e., a light-transmitting structure).

However, the first optical area OA1 and the second optical area OA2 may include not only a plurality of emission areas EA but also a plurality of transmissive areas TA.

In other words, the first optical area OA1 may include a plurality of emission areas EA and a plurality of the first transmissive areas TA1, and the second optical area OA2 may include a plurality of emission areas EA and a plurality of the second transmissive areas TA2.

The plurality of emission areas EA and the plurality of transmissive areas TA1 and TA2 may be distinguished based on whether they allow light transmission. That is, the plurality of emission areas EA may be areas where light transmission is not possible, whereas the plurality of transmissive areas TA1 and TA2 may be areas where light transmission is possible.

Additionally, the plurality of emission areas EA and the plurality of transmissive areas TA1 and TA2 may be distinguished based on the presence or absence of a specific metal layer. For example, in the plurality of emission areas EA, a cathode electrode CE may be formed, whereas in the plurality of transmissive areas TA1 and TA2, a cathode electrode CE may not be formed. Similarly, a light shield layer may be formed in the plurality of emission areas EA, whereas a light shield layer may not be formed in the plurality of transmissive areas TA1 and TA2. The cathode electrode CE may be a common electrode.

Since the first optical area OA1 includes a plurality of the first transmissive areas TA1, and the second optical area OA2 also includes a plurality of the second transmissive areas TA2, the first optical area OA1 and the second optical area OA2 may be defined as areas where light (e.g., external light) can pass through.

The transmittance (degree of transmission) of the first optical area OA1 and the transmittance of the second optical area OA2 may be the same.

In this case, the first transmissive area TA1 of the first optical area OA1 and the second transmissive area TA2 of the second optical area OA2 may have the same shape or size. Alternatively, even if the first transmissive area TA1 of the first optical area OA1 and the second transmissive area TA2 of the second optical area OA2 have different shapes or sizes, the ratio of the first transmissive area TA1 within the first optical area OA1 and the ratio of the second transmissive area TA2 within the second optical area OA2 may be the same.

On the other hand, the transmittance (degree of transmission) of the first optical area OA1 and the transmittance of the second optical area OA2 may be different.

In this case, the first transmissive area TA1 of the first optical area OA1 and the second transmissive area TA2 of the second optical area OA2 may have different shapes or sizes. Alternatively, even if the first transmissive area TA1 of the first optical area OA1 and the second transmissive area TA2 of the second optical area OA2 have the same shape or size, the ratio of the first transmissive area TA1 within the first optical area OA1 and the ratio of the second transmissive area TA2 within the second optical area OA2 may be different.

For example, if the first optoelectronic device 11, which overlaps the first optical area OA1, is a camera, and the second optoelectronic device 12, which overlaps the second optical area OA2, is a sensing sensor, the camera may require a greater amount of light than the sensing sensor.

Accordingly, the transmittance (degree of transmission) of the first optical area OA1 may be higher than the transmittance of the second optical area OA2.

In this case, the first transmissive area TA1 of the first optical area OA1 may be larger than the second transmissive area TA2 of the second optical area OA2. Alternatively, even if the first transmissive area TA1 of the first optical area OA1 and the second transmissive area TA2 of the second optical area OA2 have the same size, the ratio of the first transmissive area TA1 within the first optical area OA1 may be greater than the ratio of the second transmissive area TA2 within the second optical area OA2.

As shown in FIG. 4, in the embodiments of the present disclosure, the transmissive areas TA1 and TA2 may also be referred to as transparent areas, and transmittance may also be referred to as transparency.

Additionally, as shown in FIG. 4, in the embodiments of the present disclosure, it is assumed that the first optical area OA1 and the second optical area OA2 are located at an upper portion of the display area DA of the display panel 110 and are arranged side by side.

Referring to FIG. 4, the horizontal display area in which the first optical area OA1 and the second optical area OA2 are arranged may be defined as the first horizontal display area HA1, and the horizontal display area in which the first optical area OA1 and the second optical area OA2 are not arranged may be defined as the second horizontal display area HA2.

Referring to FIG. 4, the first horizontal display area HA1 may include the general area NA, the first optical area OA1, and the second optical area OA2. The second horizontal display area HA2 may include only the general area NA.

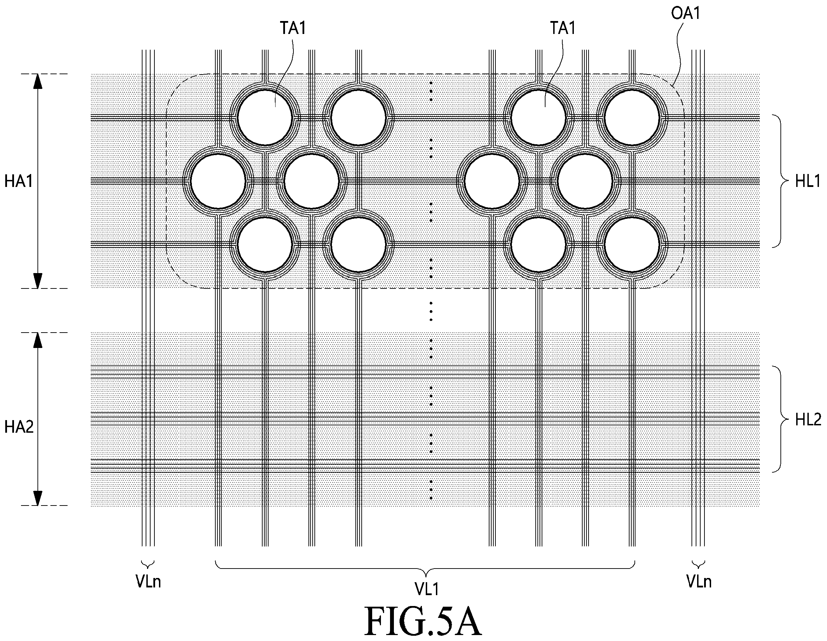

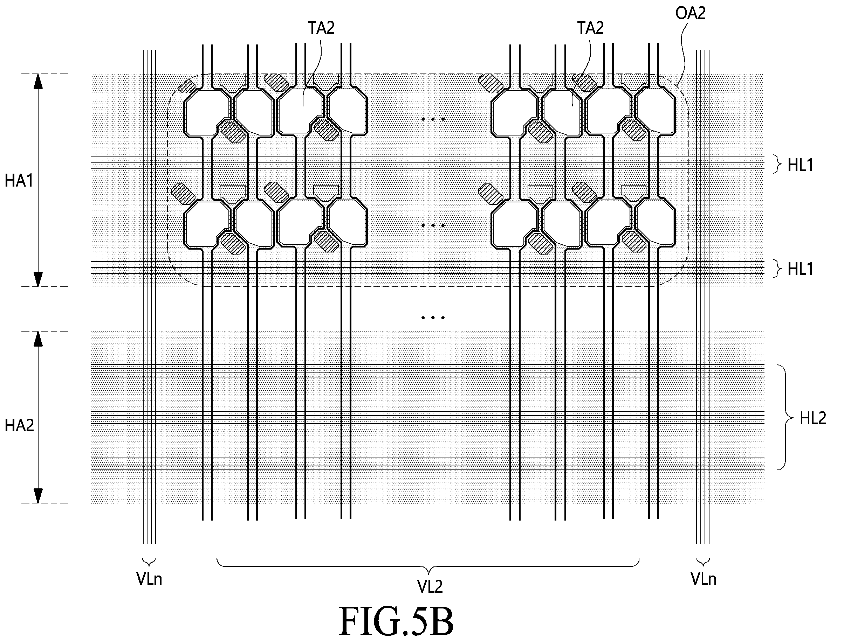

FIG. 5A and FIG. 5B are diagrams for illustrating the arrangement of signal lines in the display panel 110 according to embodiments of the present disclosure.

Specifically, FIG. 5A illustrates a layout diagram of signal lines in each of the first optical area OA1 and the general area NA according to embodiments of the present disclosure, and FIG. 5B illustrates a layout diagram of signal lines in each of the second optical area OA2 and the general area NA according to embodiments of the present disclosure.

The first horizontal display area HA1 shown in FIG. 5A and FIG. 5B is a part of the first horizontal display area HA1 in the display panel 110, and the second horizontal display area HA2 is a part of the second horizontal display area HA2 in the display panel 110.

The first optical area OA1 shown in FIG. 5A is a part of the first optical area OA1 in the display panel 110, and the second optical area OA2 shown in FIG. 5B is a part of the second optical area OA2 in the display panel 110.

Referring to FIG. 5A and FIG. 5B, the first horizontal display area HA1 may include the general area NA, the first optical area OA1, and the second optical area OA2. The second horizontal display area HA2 may include the general area NA.

Various types of horizontal lines HL1 and HL2 and various types of vertical lines VLn, VL1, and VL2 may be arranged in the display panel 110.

In the embodiments of the present disclosure, the horizontal direction and the vertical direction refer to two intersecting directions, and they may vary depending on the viewing orientation. For example, in the embodiments of the present disclosure, the horizontal direction may refer to the direction in which a gate line GL extends and is arranged, and the vertical direction may refer to the direction in which a data line DL extends and is arranged. Thus, the terms horizontal and vertical are used as examples.

Referring to FIG. 5A and FIG. 5B, the horizontal lines arranged in the display panel 110 may include the first horizontal lines HL1, which are arranged in the first horizontal display area HA1, and the second horizontal lines HL2, which are arranged in the second horizontal display area HA2.

The horizontal lines arranged in the display panel 110 may be gate lines GL. That is, the first horizontal lines HL1 and the second horizontal lines HL2 may be gate lines GL. The gate lines GL may include various types of gate lines depending on the structure of the sub-pixel SP.

Referring to FIG. 5A and FIG. 5B, the vertical lines arranged in the display panel 110 may include general vertical lines VLn, which are arranged only in the general area NA, first vertical lines VL1, which pass through both the first optical area OA1 and the general area NA, and second vertical lines VL2, which pass through both the second optical area OA2 and the general area NA.

The vertical lines arranged in the display panel 110 may include data lines DL and driving voltage lines DVL. Additionally, they may further include reference voltage lines, initialization voltage lines, and others. That is, the general vertical lines VLn, the first vertical lines VL1, and the second vertical lines VL2 may include data lines DL and driving voltage lines DVL, and may further include reference voltage lines and initialization voltage lines.

In the embodiments of the present disclosure, the term "horizontal" in second horizontal lines HL2 only means that the signal is transmitted from the left (or right) to the right (or left); it does not necessarily mean that the second horizontal lines HL2 extend strictly in a straight horizontal direction. That is, although the second horizontal lines HL2 are depicted as straight lines in FIG. 5A and FIG. 5B, they may instead include bent or curved sections. Similarly, the first horizontal lines HL1 may also include bent or curved sections.

In the embodiments of the present disclosure, the term "vertical" in general vertical lines VLn only means that the signal is transmitted from the top (or bottom) to the bottom (or top); it does not necessarily mean that the general vertical lines VLn extend strictly in a straight vertical direction. That is, although the general vertical lines VLn are depicted as straight lines in FIG. 5A and FIG. 5B, they may instead include bent or curved sections. Similarly, the first vertical lines VL1 and the second vertical lines VL2 may also include bent or curved sections.

Referring to FIG. 4 and FIG. 5A, the first optical area OA1 included in the first horizontal display area HA1 may include a plurality of emission areas EA and a plurality of the first transmissive areas TA1. The outer area of the plurality of the first transmissive areas TA1 in the first optical area OA1 may include a plurality of emission areas EA.

Referring to FIG. 5A, to improve the transmittance of the first optical area OA1, the first horizontal lines HL1, which pass through the first optical area OA1, may be arranged to avoid the plurality of the first transmissive areas TA1 within the first optical area OA1.

Accordingly, each of the first horizontal lines HL1 passing through the first optical area OA1 may include a curved section or a bending section that bypasses the outer boundary of the plurality of the first transmissive areas TA1 in the first optical area OA1.

As a result, the first horizontal lines HL1 arranged in the first horizontal display area HA1 and the second horizontal lines HL2 arranged in the second horizontal display area HA2 may differ in shape or length. That is, the first horizontal line HL1, which passes through the first optical area OA1, and the second horizontal line HL2, which does not pass through the first optical area OA1, may differ in shape or length.

Additionally, to improve the transmittance of the first optical area OA1, the first vertical lines VL1 passing through the first optical area OA1 may be arranged to avoid the plurality of the first transmissive areas TA1 within the first optical area OA1.

Accordingly, each of the first vertical lines VL1 passing through the first optical area OA1 may include a curved section or a bending section that bypasses the outer boundary of the plurality of first transmissive areas TA1 in the first optical area OA1.

As a result, the first vertical line VL1, which passes through the first optical area OA1, and the general vertical line VLn, which does not pass through the first optical area OA1 and is arranged in the general area NA, may differ in shape or length.

Referring to FIG. 5A, the first transmissive area TA1 included in the first optical area OA1 within the first horizontal display area HA1 may be arranged diagonally.

Referring to FIG. 5A, in the first optical area OA1 within the first horizontal display area HA1, a plurality of emission areas EA may be arranged between two adjacent transmissive area TA1 in the left-right direction. Similarly, in the first optical area OA1 within the first horizontal display area HA1, a plurality of emission areas EA may be arranged between two adjacent transmissive area TA1 in the top-bottom direction.

Referring to FIG. 5A, each of the first horizontal lines HL1 arranged in the first horizontal display area HA1, that is, the first horizontal lines HL1 passing through the first optical area OA1, may include at least one curved section or bending section that bypasses the outer boundary of the first transmissive area TA1.

Referring to FIG. 5B, the second optical area OA2 included in the first horizontal display area HA1 may include a plurality of emission areas EA and a plurality of second transmissive areas TA2. In the second optical area OA2, the outer region of the plurality of second transmissive areas TA2 may include a plurality of emission areas EA.

The arrangement and position of the plurality of emission areas EA and the plurality of second transmissive areas TA2 within the second optical area OA2 may be the same as those of the plurality of emission areas EA and the plurality of first transmissive areas TA1 within the first optical area OA1 in FIG. 5A.

Alternatively, as shown in FIG. 5B, the arrangement and position of the plurality of emission areas EA and the plurality of second transmissive areas TA2 within the second optical area OA2 may differ from those of the plurality of emission areas EA and the plurality of first transmissive areas TA1 within the first optical area OA1 in FIG. 5A.

For example, referring to FIG. 4 and FIG. 5B, in the second optical area OA2, the plurality of second transmissive areas TA2 may be arranged in the horizontal direction (left-right direction). Between two horizontally adjacent transmissive area TA2, emission areas EA may not be arranged. Additionally, the plurality of emission areas EA in the second optical area OA2 may be arranged between the second transmissive area TA2 that are adjacent in the vertical direction (top-bottom direction). That is, a plurality of emission areas EA may be arranged between two rows of transmissive area TA2.

When the first horizontal lines HL1 pass through the second optical area OA2 and its surrounding general area NA in the first horizontal display area HA1, they may pass in the same form as in FIG. 5A.

Alternatively, as shown in FIG. 5B, when the first horizontal lines HL1 pass through the second optical area OA2 and its surrounding general area NA in the first horizontal display area HA1, they may pass in a different form than in FIG. 5A.

This is because the arrangement and position of the plurality of emission areas EA and the plurality of second transmissive areas TA2 in the second optical area OA2 in FIG. 5B differ from those of the plurality of emission areas EA and the plurality of first transmissive areas TA1 in the first optical area OA1 in FIG. 5A.

Referring to FIG. 5B, when the first horizontal lines HL1 pass through the second optical area OA2 and its surrounding general area NA in the first horizontal display area HA1, they may pass in a straight form between the vertically adjacent transmissive areas TA2 without a curved section or bending section.

In other words, a single first horizontal line HL1 may have a curved section or bending section in the first optical area OA1, but it may not have a curved section or bending section in the second optical area OA2.

To improve the transmittance of the second optical area OA2, the second vertical lines VL2 passing through the second optical area OA2 may be arranged to avoid the plurality of second transmissive areas TA2 within the second optical area OA2.

Accordingly, each of the second vertical lines VL2 passing through the second optical area OA2 may include a curved section or a bending section that bypasses the outer boundary of the plurality of second transmissive areas TA2.

As a result, the second vertical line VL2, which passes through the second optical area OA2, and the general vertical line VLn, which does not pass through the second optical area OA2 and is arranged in the general area NA, may differ in shape or length.

As shown in FIG. 5A, the first horizontal line HL1 passing through the first optical area OA1 may have curved sections or bending sections that bypass the outer boundary of the plurality of first transmissive areas TA1 in the first optical area OA1.

Accordingly, the length of the first horizontal line HL1 passing through the first optical area OA1 and the second optical area OA2 may be slightly longer than the length of the second horizontal line HL2, which is arranged only in the general area NA without passing through the first optical area OA1 and the second optical area OA2.

As a result, the resistance of the first horizontal line HL1 (hereinafter also referred to as first resistance) passing through the first optical area OA1 and the second optical area OA2 may be slightly higher than the resistance of the second horizontal line HL2 (hereinafter also referred to as second resistance) arranged only in the general area NA without passing through the first optical area OA1 and the second optical area OA2.

Referring to FIG. 5A and FIG. 5B, due to the light-transmission structure, the first optical area OA1, which at least partially overlaps the first optoelectronic device 11, includes a plurality of first transmissive areas TA1, and the second optical area OA2, which at least partially overlaps the second optoelectronic device 12, includes a plurality of second transmissive areas TA2. Accordingly, the first optical area OA1 and the second optical area OA2 may have fewer sub-pixels per unit area than the general area NA.

The number of sub-pixels SP connected to the first horizontal line HL1, which passes through the first optical area OA1 and the second optical area OA2, may differ from the number of sub-pixels SP connected to the second horizontal line HL2, which is arranged only in the general area NA without passing through the first optical area OA1 and the second optical area OA2.

The number of sub-pixels SP connected to the first horizontal line HL1 (hereinafter referred to as first number) passing through the first optical area OA1 and the second optical area OA2 may be smaller than the number of sub-pixels SP connected to the second horizontal line HL2 (hereinafter referred to as second number) arranged only in the general area NA without passing through the first optical area OA1 and the second optical area OA2.

The difference between the first number and the second number may vary depending on the resolution difference between the first optical area OA1 or the second optical area OA2, and the general area NA. For example, the larger the resolution difference between the first optical area OA1 or the second optical area OA2, and the general area NA, the larger the difference between the first number and the second number may be.

As described above, the number of sub-pixels SP connected to the first horizontal line HL1, which passes through the first optical area OA1 and the second optical area OA2 (hereinafter referred to as the first number), is smaller than the number of sub-pixels SP connected to the second horizontal line HL2, which is arranged only in the general area NA without passing through the first optical area OA1 and the second optical area OA2 (hereinafter referred to as the second number). Accordingly, the overlapping area between the first horizontal line HL1 and surrounding electrodes or lines may be smaller than the overlapping area between the second horizontal line HL2 and surrounding electrodes or lines.

Accordingly, the parasitic capacitance (hereinafter referred to as first capacitance) formed between the first horizontal line HL1 and surrounding electrodes or lines may be significantly smaller than the parasitic capacitance (hereinafter referred to as second capacitance) formed between the second horizontal line HL2 and surrounding electrodes or lines.

Considering the relationship between the first resistance and the second resistance (first resistance ≥ second resistance) and the relationship between the first capacitance and the second capacitance (first capacitance « second capacitance), the RC (Resistance-Capacitance) value of the first horizontal line HL1 (hereinafter also referred to as the first RC value), which passes through the first optical area OA1 and the second optical area OA2, may be much smaller than the RC value of the second horizontal line HL2 (hereinafter also referred to as the second RC value), which is arranged only in the general area NA without passing through the first optical area OA1 and the second optical area OA2 (first RC value « second RC value).

Due to the difference between the first RC value of the first horizontal line HL1 and the second RC value of the second horizontal line HL2 (hereinafter referred to as RC load deviation), the signal transmission characteristics through the first horizontal line HL1 and the second horizontal line HL2 may differ.

Hereinafter, for ease of explanation, at least one of the first optical area OA1 and/or the second optical area OA2 may be referred to as the optical area OA, and at least one of the plurality of first transmissive areas TA1 in the first optical area OA1 and the plurality of second transmissive areas TA2 in the second optical area OA2 may be referred to as the transmissive area TA.

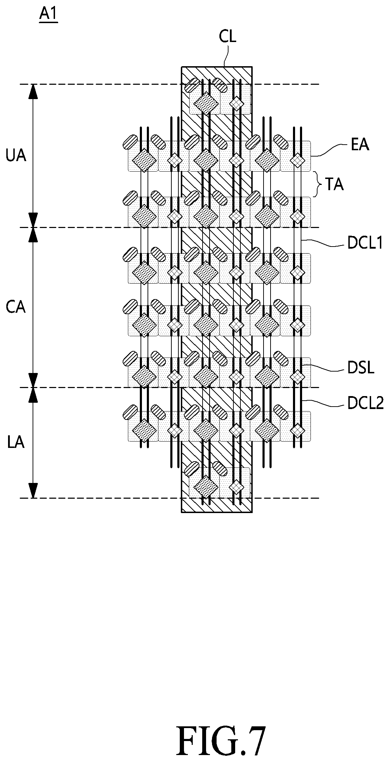

FIG. 6 and FIG. 7 are diagrams illustrating the optical area OA according to embodiments of the present disclosure.

Specifically, FIG. 6 illustrates a plan view of the optical area OA according to embodiments of the present disclosure, and FIG. 7 illustrates a plan view in which only the first area A1 is represented in the plan view of FIG. 6.

Referring to FIG. 6 and FIG. 7, the optical area OA may include a plurality of transmissive areas TA and a plurality of first emission areas EA1.

In FIGS. 6 and 7, for ease of explanation, the optical area OA is illustrated such that the first emission areas EA1 are arranged only in the odd-numbered rows, and the transmissive areas TA are arranged only in the even-numbered rows. However, embodiments of the present disclosure are not limited thereto, and at least one transmissive area TA may be additionally arranged between the first emission areas EA1 in a single row.

In each of the plurality of first emission areas EA1, at least one sub-pixel selected from a first-color sub-pixel SP1 (e.g., green), a second-color sub-pixel SP2 (e.g., blue), and a third-color sub-pixel SP3 (e.g., red) may be arranged.

For example, in the plurality of first emission areas EA1, a second-color sub-pixel SP2 may be arranged in a first-1 emission area, a third-color sub-pixel SP3 may be arranged in a first-2 emission area adjacent to the first-1 emission area, and a first-color sub-pixel SP1 may be arranged at the boundary between the first-1 emission area and the first-2 emission area. However, embodiments of the present disclosure are not limited thereto.

The shape and size of at least two or more sub-pixels among the first-color sub-pixel SP1, the second-color sub-pixel SP2, and the third-color sub-pixel SP3 may be either the same or different.

According to the examples in FIG. 6 and FIG. 7, considering the lifetime and luminous efficiency of the emission material for each color, the second-color sub-pixel SP2 may be formed larger than the first-color sub-pixel SP1 and the third-color sub-pixel SP3. However, embodiments of the present disclosure are not limited thereto.

According to the examples in FIG. 6 and FIG. 7, in order to improve the transmittance in the optical area OA, it is necessary to reduce the use of low-transmittance wiring, such as metal wiring, in the transmissive area TA. In other words, applying high-transmittance wiring to the transmissive area TA needs to be considered.

However, high-transmittance wiring has higher resistance compared to conventional wiring (e.g., low-transmittance wiring or metal wiring). Due to the structural characteristics of the optical area OA, which is implemented in a circular shape, applying high-transmittance wiring to all transmissive areas TA may cause a significant resistance difference between the center region (with longer wiring) and the edge region (with shorter wiring), leading to luminance variation issues.

Accordingly, the display device 100 according to embodiments of the present disclosure applies high-transmittance wiring to a plurality of transmissive areas TA. However, by differentially applying high-transmittance wiring while considering the resistance difference between the center region and the edge region, the display device 100 may minimize luminance variation caused by wiring resistance differences while improving transmittance in the plurality of transmissive areas TA.

Hereinafter, examples of differentially applying high-transmittance wiring will be described in detail.

For example, in the emission areas EA, since there is no requirement in terms of transmittance, the data lines DL (e.g., the data sub-lines DSL and the second conncetion line DCL2) may be made of metals such as Ti, Al, or Cu.

However, in the transmissive areas TA, due to the transmittance requirement, the data conncetion lines DCL (e.g., the first connection line DCL 1) are made of Transparent Conductive Oxide (TCO) materials.

Specifically, in an area where a plurality of data lines DL overlap the optical area OA, the plurality of data lines DL may include a plurality of data connection lines, which are disposed in a first direction in at least one of the plurality of transmissive areas TA, and a plurality of data sub-lines DSL, which are disposed in a first direction in the plurality of first emission areas EA1 and electrically connected to at least one of the corresponding data connection lines, for example, at least one of at least one first connection line DCL1 and at least one second connection line DCL2.

The plurality of data connection lines may include at least one first connection line DCL1, which is disposed in the first area A1 and the second area A2 of the optical area OA, and at least one second connection line DCL2, which is disposed in the first area A1 and has a lower resistance than the first connection line DCL1.

For example, the first connection line DCL1 may be high-transmittance wiring with a transmittance of 80% to 99%. As an example, the first connection line DCL1 may include at least one material selected from ITO (Indium Tin Oxide), IGZO (Indium Gallium Zinc Oxide), and IZO (Indium Zinc Oxide), which are TCO materials. Therefore, the first connection line DCL1 may have a higher transmittance than any one of the second connection line DCL2 and the data sub-lines DSL.

The second connection line DCL2 and the data sub-lines DSL may be wiring with a sheet resistance of 0.01 to 0.05. As an example, the second connection line DCL2 and the data sub-lines DSL may include aluminum (Al). In other words, the second connection line DCL2 and the data sub-lines DSL may be wiring made of the same material. That is, like the second connection line DCL2, the data sub-lines DSL may have a lower resistance than the first connection line DCL1.

However, embodiments of the present disclosure are not limited thereto, and at least one of the plurality of data sub-lines DSL may include the same material as the first connection line DCL1.

For example, the first connection line DCL1 may be formed in a different layer from the second connection line DCL2 and the data sub-lines DSL. The second connection line DCL2 and the data sub-lines DSL may be formed of the same material in the same layer.

According to the examples in FIG. 6 and FIG. 7, the first area A1 is a region located at the center of the optical area OA, and the second area A2 is a region located on each of the first side (e.g., left side) and the second side (e.g., right side) of the first area A1.

That is, in the display device 100 according to embodiments of the present disclosure, the first connection line DCL1, which is high-transmittance/high-resistance wiring, and the second connection line DCL2, which is low-resistance wiring, are differentially arranged in the first area A1, which corresponds to the center of the optical area OA. Meanwhile, in the second area A2, which corresponds to the edge of the optical area OA, only the first connection line DCL1 (high-transmittance/high-resistance wiring) is arranged. Accordingly, the resistance difference between the long wiring at the center and the short wiring at the edges can be minimized.

According to embodiments of the present disclosure, the display device 100 may be designed to minimize the difference in wiring resistance between the center and edge regions by varying the wiring widths of at least one of the plurality of data connection lines disposed in the first area A1 and at least one of the plurality of data connection lines disposed in the second area A2 among the plurality of data connection lines.

For example, at least one data connection line disposed in the first area A1 among the plurality of data connection lines may be designed with a greater wiring width than at least one data connection line disposed in the second area A2 among the plurality of data connection lines, thus differentially designing the wiring width.

More specifically, in the display device 100, the first connection line DCL1 disposed in the center line region CL, where the wiring length is the longest, may be designed with the largest wiring width, and the wiring width of the first connection line DCL1 may gradually decrease as it moves away from the center line region CL.

According to embodiments of the present disclosure, in order to minimize the difference in wiring resistance between the center region and the edge region, the display device 100 may be designed such that at least one of the plurality of data connection lines disposed in the first area A1 and at least one of the plurality of data connection lines disposed in the second area A2 among the plurality of data connection lines have different wiring lengths.

In the display device 100 according to embodiments of the present disclosure, any of wirings diposed in the second area A2 may be lines with curves or angular turns, wherein the lines with curves or angular turns may include a zigzag pattern (i.e., DP shown in FIG. 6).

Specifically, the writings disposed in the second area A2, which are lines with curves or angular turns, may include any one of a power line, a power conncetion line, a low potential line, the data connection line DCL, and the data sub-line DSL.

For example, at least one data connection line disposed in the second area A2 among the plurality of data connection lines DCL may be lines with curves or angular turns to differentially design the wiring length of the data connection lines. Further, the at least one data connection lines DCL disposed in the second area A2 may be lines with a zigzag pattern DP.

In another example, in order to minimize the resistance difference between the center and edge regions of the optical area OA, at least one of the plurality of data sub-lines DSL disposed in the second area A2 may be lines with curves or angular turns. Further, at least one data sub-lines DSL disposed in the second area A2 may be lines with a zigzag pattern (not shown).

Referring to FIG. 7, the first area A1 may be divided into an upper area UA, a intermediate area CA, and a lower area LA. In the first area A1, the first connection line DCL1 may be disposed in the intermediate area CA, and the second connection line DCL2 may be disposed in at least one of the upper area UA and the lower area LA.

In the first area A1, the first connection line DCL1 may be disposed in at least one of the upper area UA and the lower area LA. As a result, at least one of the upper area UA and the lower area LA may include both the first connection line DCL1 and the second connection line DCL2 arranged together.

In other words, in order to minimize the resistance difference between the center and edge regions of the optical area OA, the display device 100 according to embodiments of the present disclosure may differentially arrange the first connection line DCL1 and the second connection line DCL2. However, to minimize the decrease in transmittance in the transmissive area TA, the second connection line DCL2 may be disposed only in the upper area UA and/or the lower area LA of the first area A1.

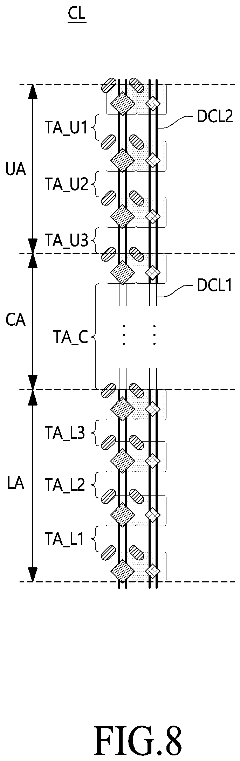

FIG. 8 to FIG. 13 are diagrams for illustrating embodiments according to various combinations of the first connection line DCL1 and the second connection line DCL2 in the display device 100 according to embodiments of the present disclosure.

Specifically, FIG. 8 to FIG. 13 illustrate embodiments according to various combinations of the first connection line DCL1 and the second connection line DCL2 in the center line region CL shown in FIG. 7.

Referring to FIG. 8 to FIG. 13, in the first area A1, the first connection line DCL1 may be disposed in at least one of the transmissive areas TA located in at least one of the upper area UA, the intermediate area CA, and the lower area LA. The second connection line DCL2 may be disposed in at least one of the transmissive areas TA located in at least one of the upper area UA and the lower area LA.

According to the examples of FIG. 8 to FIG. 13, in each of the plurality of intermediate transmissive areas TA_C located in the intermediate area CA, the first connection line DCL1 may be arranged.

According to the example of FIG. 8, in each of the first to third upper transmissive areas TA_U1, TA_U2 and TA_U3 located in the upper area UA and in each of the first to third lower transmissive areas TA_L1, TA_L2 and TA_L3 located in the lower area LA, the second connection line DCL2 may be disposed.

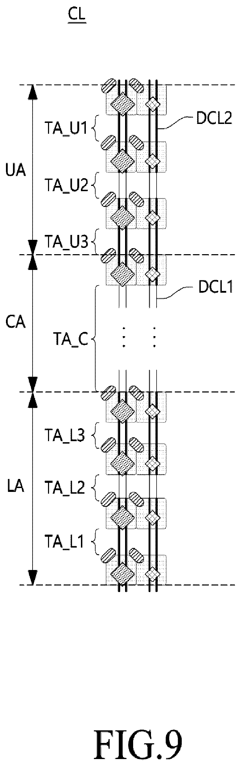

According to the example of FIG. 9, the second connection line DCL2 may be disposed in each of the first upper transmissive area TA_U1, the third upper transmissive area TA_U3, the first lower transmissive area TA_L1, and the third lower transmissive area TA_L3, whereas the first connection line DCL1 may be disposed in each of the second upper transmissive area TA_U2 and the second lower transmissive area TA_L2.

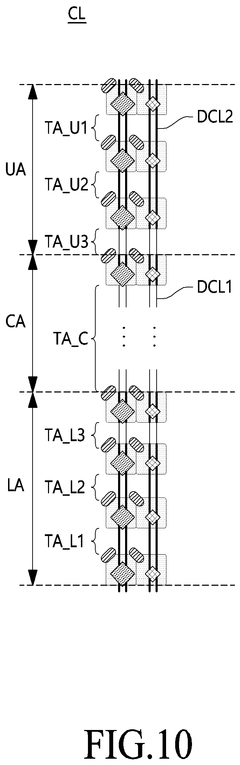

According to the example of FIG. 10, the second connection line DCL2 may be disposed in each of the first upper transmissive area TA_U1, the second upper transmissive area TA_U2, the first lower transmissive area TA_L1, and the second lower transmissive area TA_L2, whereas the first connection line DCL1 may be disposed in each of the third upper transmissive area TA_U3 and the third lower transmissive area TA_L3.

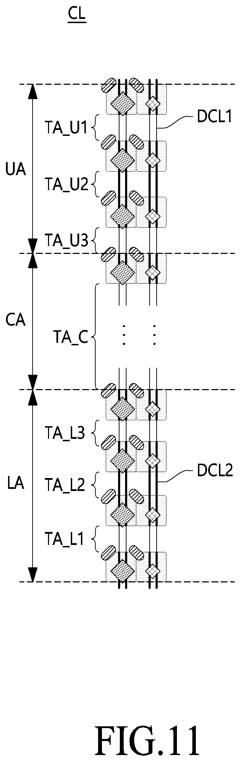

According to the example of FIG. 11, the second connection line DCL2 may be disposed in each of the second upper transmissive area TA_U2 and the second lower transmissive area TA_L2, whereas the first connection line DCL1 may be disposed in each of the first upper transmissive area TA_U1, the third upper transmissive area TA_U3, the first lower transmissive area TA_L1, and the third lower transmissive area TA_L3.

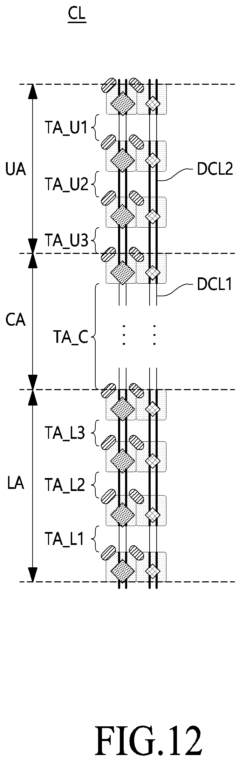

According to the example of FIG. 12, the second connection line DCL2 may be disposed in each of the second upper transmissive area TA_U2, the third upper transmissive area TA_U3, the second lower transmissive area TA_12, and the third lower transmissive area TA_L3, whereas the first connection line DCL1 may be disposed in each of the first upper transmissive area TA_U1 and the first lower transmissive area TA_L1.

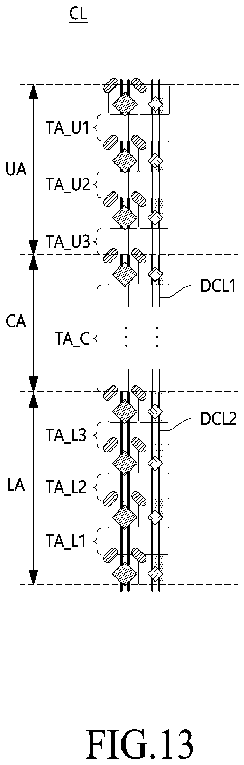

According to the example of FIG. 13, the first connection line DCL1 may be disposed in each of the first to third upper transmissive areas TA_U1, TA_U2, and TA_U3, whereas the second connection line DCL2 may be disposed in each of the first to third lower transmissive areas TA_L1, TA_L2, and TA_L3.

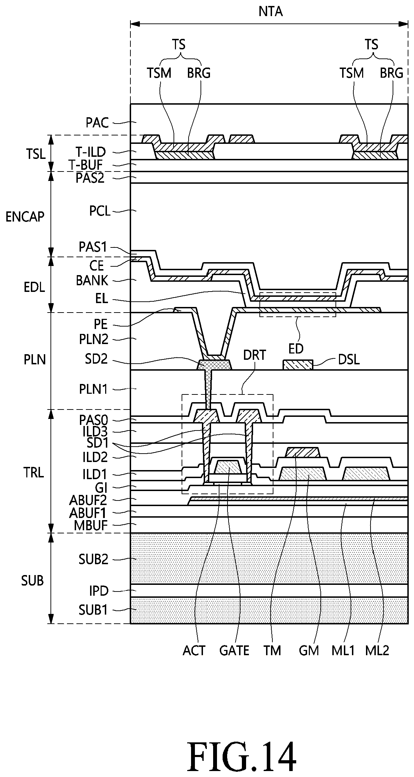

FIG. 14 to FIG. 18 are diagrams for illustrating implementation examples of the display device 100 according to embodiments of the present disclosure.

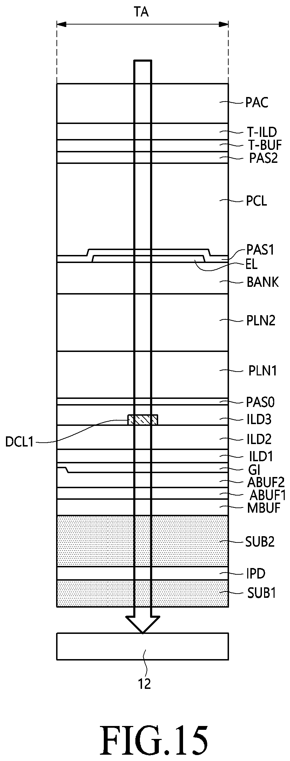

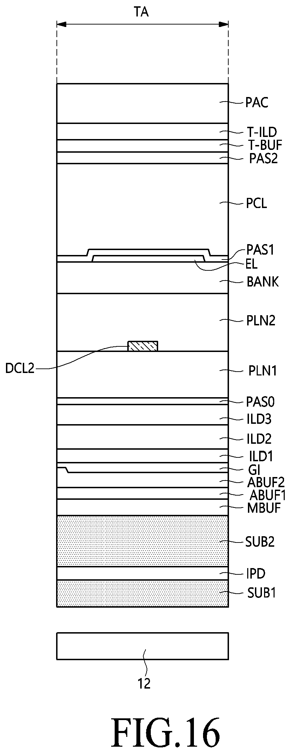

Specifically, FIG. 14 illustrates a cross-sectional view of a non-transmissive area NTA of the optical area OA included in the display device 100 according to embodiments of the present disclosure, and FIG. 15 and FIG. 16 illustrate cross-sectional views of the transmissive area TA of the optical area OA.

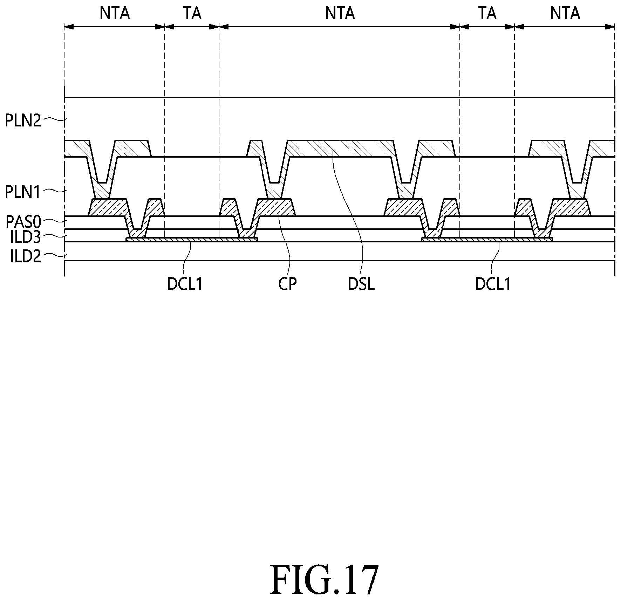

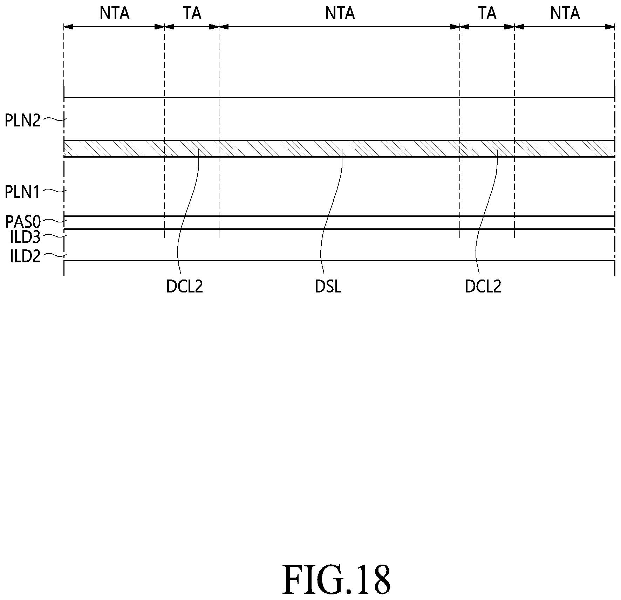

Additionally, FIG. 17 illustrates a cross-sectional view showing the connection relationship between the first connection line DCL1 and the data sub-line DSL when the data connection line disposed in the transmissive area TA is the first connection line DCL1. FIG. 18 illustrates a cross-sectional view showing the connection relationship between the second connection line DCL2 and the data sub-line DSL when the data connection line disposed in the transmissive area TA is the second connection line DCL2.

More specifically, FIG. 17 illustrates a cross-sectional view in which the first connection line DCL1 is disposed in at least one transmissive area TA adjacent to the non-transmissive area NTA including the first emission area, and FIG. 18 illustrates a cross-sectional view in which the second connection line DCL2 is disposed in at least one transmissive area TA adjacent to the non-transmissive area NTA including the first emission area.

Referring to FIG. 14 to FIG. 16, the display device 100 according to embodiments of the present disclosure may include a non-transmissive area NTA and a transmissive area TA within the optical area OA. The non-transmissive area NTA may include the first emission area EA1.

In the examples of FIG. 14 to FIG. 16, for the sake of explanation, the transmissive area TA of the optical area OA is illustrated as overlapping with the first optoelectronic device 11. However, the transmissive area TA of the optical area OA may also overlap with the second optoelectronic device 12.

Additionally, although the first optoelectronic device 11 is illustrated as overlapping with the transmissive area TA in the examples of FIG. 14 to FIG. 16, the first optoelectronic device 11 may also overlap with at least a portion of the non-transmissive area NTA included in the optical area OA.

The non-transmissive area NTA and the transmissive area TA may include a substrate SUB, a transistor layer TRL, a planarization layer PLN, a light-emitting device layer EDL, an encapsulation layer ENCAP, a touch sensor layer TSL, and a protective layer PAC.

First, referring to FIG. 14, the laminated structure of the non-transmissive area NTA will be described.

The substrate SUB may include a first substrate SUB1, an intermediate insulating layer IPD, and a second substrate SUB2. The intermediate insulating layer IPD may be located between the first substrate SUB 1 and the second substrate SUB2. By forming the substrate SUB with the first substrate SUB1, the intermediate insulating layer IPD, and the second substrate SUB2, moisture infiltration can be prevented. For example, the first substrate SUB1 and the second substrate SUB2 may be polyimide (PI) substrates. The intermediate insulating layer IPD may include an inorganic material. For example, the intermediate insulating layer IPD may include silicon nitride (SiNx) or silicon oxide (SiOx).

The transistor layer TRL disposed on the substrate SUB may include various patterns (ACT, SD1, GATE) for forming transistors such as the driving transistor DRT, various insulating films (MBUF, ABUF1, ABUF2, GI, ILD1, ILD2, ILD3, PAS0), and various metal patterns (TM, GM, ML1, ML2).

According to embodiments, at least one additional insulating film may be further disposed between the second interlayer insulating film ILD2 and the third interlayer insulating film ILD3 and/or between the third interlayer insulating film ILD3 and the passivation layer PASO.

Hereinafter, the laminated structure of the transistor layer TRL will be described in more detail.

A multi-buffer layer MBUF may be disposed on the second substrate SUB2, and a first active buffer layer ABUF1 may be disposed on the multi-buffer layer MBUF.

A first metal layer ML1 and a second metal layer ML2 may be disposed on the first active buffer layer ABUF1. Here, the first metal layer ML1 and the second metal layer ML2 may serve as a light shield.

A second active buffer layer ABUF2 may be disposed on the first metal layer ML1 and the second metal layer ML2, and an active layer ACT of the driving transistor DRT may be disposed on the second active buffer layer ABUF2.

A gate insulating film GI may be disposed covering the active layer ACT.

A gate electrode GATE of the driving transistor DRT may be disposed on the gate insulating film GI. In this case, at a position different from where the driving transistor DRT is formed, a gate material layer GM may be disposed on the gate insulating film GI along with the gate electrode GATE of the driving transistor DRT.

A first interlayer insulating film ILD1 may be disposed covering the gate electrode GATE and the gate material layer GM. A metal pattern TM may be disposed on the first interlayer insulating film ILD1. A second interlayer insulating film ILD2 may be disposed covering the metal pattern TM on the first interlayer insulating film ILD1.

A third interlayer insulating film ILD3 may be disposed on the second interlayer insulating film ILD2, and two first source-drain electrode patterns SD1 may be disposed on the third interlayer insulating film ILD3. Among the two first source-drain electrode patterns SD1, one may be the source node of the driving transistor DRT, and the other may be the drain node of the driving transistor DRT.

The two first source-drain electrode patterns SD1 may be connected to one side and the other side of the active layer ACT through contact holes of the third interlayer insulating film ILD3, the second interlayer insulating film ILD2, the first interlayer insulating film ILD1, and the gate insulating film GI. The portion of the active layer ACT overlapping the gate electrode GATE may be a channel region. Among the two first source-drain electrode patterns SD1, one may be connected to one side of the channel region in the active layer ACT, and the other may be connected to the other side of the channel region in the active layer ACT.

A passivation layer PAS0 may be disposed covering the two first source-drain electrode patterns SD1.

A planarization layer PLN may be disposed on the transistor layer TRL. The planarization layer PLN may include a first planarization layer PLN1 and a second planarization layer PLN2.

The first planarization layer PLN1 may be disposed on the passivation layer PASO. A second source-drain electrode pattern SD2 may be disposed on the first planarization layer PLN1. The second source-drain electrode pattern SD2 may be connected to one of the two first source-drain electrode patterns SD1 (corresponding to the N2 node in FIG. 4) through a contact hole in the first planarization layer PLN1.

A data connection line DCL according to one embodiment of the present invention may be disposed above the first source-drain electrode pattern SD1 and the second source-drain electrode pattern SD2, and below the first planarization layer PLN1, that is, may be disposed between the source-drain electrode patterns (e.g., SD1 and SD2) and the planarization layer (PLN1).

A data connection line DCL according to another embodiment of the present invention may be disposed under the first source-drain electrode patterns SD1 and the second source-drain electrode patterns SD2, and may be disposed between the second interlayer insulating film ILD2 and the third interlayer insulating film ILD3.

A data sub-line DSL may be disposed on the first planarization layer PLN1.

The second planarization layer PLN2 may be disposed covering the second source-drain electrode pattern SD2 and the data sub-line DSL. A light-emitting device layer EDL may be positioned on the plurality of planarization layers, particularly the second planarization layer PLN2, and includes a plurality of light-emitting devices ED corresponding to each of the plurality of emission areas EA.

For example, the light-emitting device layer EDL may include a light-emitting device ED formed by a pixel electrode PE, an emission layer EL, and a common electrode CE. The emission layer EL may include an organic film.

The pixel electrode PE may be disposed on the second planarization layer PLN2, and the pixel electrode PE may be electrically connected to the second source-drain electrode pattern SD2 through a contact hole in the second planarization layer PLN2.

A bank BANK may be disposed covering the pixel electrode PE. The bank BANK may have an opening corresponding to the emission area of the sub-pixel SP. A portion of the pixel electrode PE may be exposed through the opening of the bank BANK. The emission layer EL may be disposed within and around the opening of the bank BANK. Accordingly, the emission layer EL may be disposed on the pixel electrode PE exposed through the opening of the bank BANK.

A common electrode CE may be disposed on the emission layer EL. For example, the common electrode CE may be a cathode electrode.

The encapsulation layer ENCAP may be disposed on the aforementioned light-emitting device layer EDL.

The encapsulation layer ENCAP may have a single-layer structure or a multi-layer structure. For example, as illustrated in FIG. 14, the encapsulation layer ENCAP may include a lower encapsulation layer PAS1, an intermediate encapsulation layer PCL, and an upper encapsulation layer PAS2.

However, the display device 100 according to embodiments of the present disclosure is not limited thereto and may include only the intermediate encapsulation layer PCL.

The lower encapsulation layer PAS1 and the upper encapsulation layer PAS2 may be inorganic films, and the intermediate encapsulation layer PCL may be an organic film or an inorganic film. The intermediate encapsulation layer PCL may function as a planarization layer.

The lower encapsulation layer PAS1 may be disposed on the common electrode CE and may be positioned closest to the light-emitting device ED. The lower encapsulation layer PAS1 may be formed of an inorganic insulating material that can be deposited at a low temperature. For example, the lower encapsulation layer PAS1 may be formed of silicon nitride SiNx, silicon oxide SiOx, silicon oxynitride SiON, or aluminum oxide Al₂O₃. Since the lower encapsulation layer PAS1 is deposited in a low-temperature environment, it can prevent the emission layer EL, which includes organic materials vulnerable to high temperatures, from being damaged during the deposition process.

The intermediate encapsulation layer PCL functions as a buffer to alleviate stress between layers caused by the bending of the display device 100 and may also enhance planarization performance. For example, the intermediate encapsulation layer PCL may be formed of an organic insulating material such as acrylic resin, epoxy resin, polyimide, polyethylene, or silicon oxycarbon SiOC. The intermediate encapsulation layer PCL may also be formed using an inkjet method.

For reference, in order to prevent the encapsulation layer ENCAP from collapsing, the display panel 110 may include at least one dam at the end point of the inclined surface of the encapsulation layer ENCAP or in the vicinity thereof. The at least one dam may be positioned at or near the boundary between the display area DA and the non-display area NDA.

The intermediate encapsulation layer PCL, which includes organic material, may be positioned only on the inner side of the first dam. That is, the intermediate encapsulation layer PCL may not be present on the upper portions of all the dams. Alternatively, the intermediate encapsulation layer PCL may be positioned on the upper portion of at least the first dam among the first dam and the second dam. In other words, the intermediate encapsulation layer PCL may extend only up to the upper portion of the first dam. Or, the intermediate encapsulation layer PCL may extend beyond the upper portion of the first dam and reach the upper portion of the second dam.

The upper encapsulation layer PAS2 may be formed on the substrate SUB, where the intermediate encapsulation layer PCL is formed, to cover the upper and side surfaces of both the intermediate encapsulation layer PCL and the lower encapsulation layer PAS1. The upper encapsulation layer PAS2 may minimize or block the infiltration of external moisture or oxygen into the lower encapsulation layer PAS1 and the intermediate encapsulation layer PCL. For example, the upper encapsulation layer PAS2 may be formed of an inorganic insulating material such as silicon nitride (SiNx), silicon oxide (SiOx), silicon oxynitride (SiON), or aluminum oxide (Al₂O₃).

A touch sensor layer TSL may be disposed on the aforementioned encapsulation layer ENCAP.

A touch buffer layer T-BUF may be disposed on the encapsulation layer ENCAP, and a touch sensor TS may be disposed on the touch buffer layer T-BUF. The touch sensor TS may include touch sensor metals TSM located on different layers and bridge metals BRG. A touch interlayer insulating film T-ILD may be disposed between the touch sensor metals TSM and the bridge metals BRG.

For example, the touch sensor metals TSM may include a first touch sensor metal TSM, a second touch sensor metal TSM, and a third touch sensor metal TSM arranged adjacent to each other. The first touch sensor metal TSM and the second touch sensor metal TSM need to be electrically connected, but if a third touch sensor metal TSM is present between them, they may be electrically connected through a bridge metal BRG positioned on a different layer. The bridge metal BRG may be insulated from the third touch sensor metal TSM by the touch interlayer insulating film T-ILD.

During the formation of the touch sensor layer TSL, processing chemicals (such as developer or etchant) or external moisture may be generated. By placing the touch buffer layer T-BUF and then forming the touch sensor layer TSL on the top of it, the penetration of processing chemicals or moisture into the emission layer EL, which contains organic materials, can be prevented during the manufacturing process of the touch sensor layer TSL. Accordingly, the touch buffer layer T-BUF can prevent damage to the emission layer EL, which is vulnerable to processing chemicals or moisture.

The touch buffer layer T-BUF is formed of an organic insulating material that has a low dielectric constant of 1 to 3 and can be formed at a low temperature (e.g., 100°C or lower), to prevent damage to the emission layer EL, which contains organic materials that are vulnerable to high temperatures. For example, the touch buffer layer T-BUF may be made of an acrylic-based material, an epoxy-based material, or a siloxane-based material. When the display device 100 is bent, the encapsulation layer ENCAP may be damaged, and the touch sensor metals located on the touch buffer layer T-BUF may break. Even if the display device 100 bends, the touch buffer layer T-BUF, which has planarization properties due to its organic insulating material, can prevent damage to the encapsulation layer ENCAP and/or the breakage of the metals (TSM, BRG) constituting the touch sensor TS.

A protective layer PAC may be disposed over the touch sensor TS. The protective layer PAC may be an organic insulating film.

According to the example in FIG. 15, in one of the plurality of transmissive areas TA, the first connection line DCL1 may be disposed on the second interlayer insulating film ILD2, and the third interlayer insulating film ILD3 may be disposed over the first connection line DCL1, covering it while being positioned on the second interlayer insulating film ILD2.

According to the example in FIG. 16, in another one of the plurality of transmissive areas TA, the second connection line DCL2 may be disposed on the first planarization layer PLN1, and the second planarization layer PLN2 may be disposed over the second connection line DCL2, covering it while being positioned on the first planarization layer PLN1.

Referring to FIG. 17, the data sub-line DSL overlapping the first emission area EA1 within at least one non-transmissive area NTA may be disposed on the first planarization layer PLN1, and the first connection line DCL1 overlapping at least one transmissive area TA adjacent to at least one non-transmissive area NTA may be disposed on any one of the plurality of interlayer insulating films, e.g., the second interlayer insulating film ILD2.

According to the example in FIG. 17, the data sub-line DSL and the first connection line DCL1, which are disposed on different layers, may be electrically connected through a connection pattern CP disposed on the passivation layer PASO.

Referring to FIG. 18, the data sub-line DSL overlapping the first emission area EA1 in at least one non-transmissive area NTA and the second connection line DCL2 overlapping at least one transmissive area TA adjacent to at least one non-transmissive area NTA may be disposed on the first planarization layer PLN1.

For example, the data sub-line DSL and the second connection line DCL2 may be formed on the same layer, specifically on any one of the plurality of planarization layers, e.g., the first planarization layer PLN1, especially in at least one of the plurality of transmissive areas TA, through a single manufacturing process using the same material.

A brief summary of the embodiments described above is as follows.

A display device according to embodiments of the present disclosure may comprise: a display panel including an optical area having a plurality of transmissive areas and a plurality of first emission areas, a general area disposed outside the optical area and having a plurality of second emission areas, and a plurality of data connection lines arranged in a first direction in at least one of the plurality of transmissive areas; and an optoelectronic device disposed below the display panel and overlapping the optical area. The plurality of data connection lines may include at least one first connection line arranged in a first area and a second area of the optical area, and at least one second connection line arranged in the first area and having a lower resistance than the at least one first connection line.

The second area may be located at each of first and second sides of the first area.

The first area may be divided into an upper area, an intermediate area, and a lower area, and the at least one second connection line may be arranged in at least one of the upper area and the lower area.

The at least one first connection line may be arranged in the intermediate area.

The at least one first connection line may be arranged in at least one of the upper area and the lower area.

At least one data connection line arranged in the first area among the plurality of data connection lines and at least one data connection line arranged in the second area among the plurality of data connection lines may have different wiring widths.

At least one data connection line arranged in the first area among the plurality of data connection lines may have a larger wiring width than at least one data connection line arranged in the second area among the plurality of data connection lines.

At least one data connection line arranged in the first area among the plurality of data connection lines and at least one data connection line arranged in the second area among the plurality of data connection lines may have different wiring lengths.

At least one data connection line arranged in the second area among the plurality of data connection lines may be lines with curves or angular turns, wherein the lines with curves or angular turns may include a zigzag pattern. The wirings disposed in the second area, which are lines with curves or angular turns, may include any one of a power line, a power connection line, a low potential line, the at least one data connection line, and a data sub-line.

The display panel may include a plurality of data sub-lines disposed in the first direction in the plurality of first emission areas and arranged in a different layer from the at least one first connection line, and at least one connection pattern that electrically connects at least one of the plurality of data sub-lines to a corresponding line among the at least one first connection line.

The plurality of data sub-lines may have a lower resistance than the at least one first connection line.

The at least one first connection line may be a high-transmittance line.

The display panel may further include a substrate, a transistor layer disposed on the substrate and including at least one transistor and a plurality of interlayer insulating films, and a plurality of planarization layers disposed on the transistor layer.

The plurality of data sub-lines may be disposed on any one of the plurality of planarization layers.

The at least one first connection line may be disposed on any one of the plurality of interlayer insulating films.

The at least one second connection line may be disposed on any one of the plurality of planarization layers.

A display device according to embodiments of the present disclosure may comprise: a substrate including a plurality of transmissive areas and a plurality of emission areas; a transistor layer disposed on the substrate and including at least one transistor and a plurality of interlayer insulating films; a plurality of planarization layers disposed on the transistor layer; a plurality of data sub-lines disposed on any one of the plurality of planarization layers in the plurality of emission areas, and electrically connected to at least one of at least one first connection line and at least one second connection line of a plurality of data connection lines; and a light-emitting device layer disposed on the plurality of planarization layers and including a plurality of light-emitting devices corresponding to each of the plurality of emission areas.

The at least one first connection line may be disposed on any one of the plurality of interlayer insulating films, in at least one of the plurality of transmissive areas.

The at least one second connection line may be disposed on any one of the plurality of planarization layers, in at least one of the plurality of transmissive areas.

A display device according to embodiments of the present disclosure may comprise: a display panel including an optical area having a plurality of transmissive areas and a plurality of first emission areas, a general area disposed outside the optical area and having a plurality of second emission areas, and a plurality of data connection lines disposed in a first direction in at least one of the plurality of transmissive areas; and an optoelectronic device disposed below the display panel and overlapping the optical area, wherein the plurality of data connection lines includes at least one first connection line disposed in a first area and a second area of the optical area, and at least one second connection line disposed in the first area, and wherein any of wirings disposed in the second area may be lines with curves or angular turns.

The lines with curves or angular turns may include a zigzag pattern.

The wirings disposed in the second area, which are lines with curves or angular turns, may include any of a power line, a power connection line, a low potential line, the at least one data connection line, and a data sub-line.

The wirings disposed in the second area, which are lines with curves or angular turns, may include the at least one data connection line.

The wirings disposed in the second area, which are lines with curves or angular turns, may include a data sub-line.

The wirings disposed in the second area, which are lines with curves or angular turns, may include the at least one data connection line and a data sub-line.

A display device according to embodiments of the present disclosure may comprise: a substrate, which includes an optical area including a plurality of transmissive areas and a plurality of emission areas; a transistor layer disposed on the substrate and including at least one transistor and a plurality of interlayer insulating films; a plurality of planarization layers disposed on the transistor layer; a plurality of data sub-lines disposed on any one of the plurality of planarization layers in the plurality of emission areas and electrically connected to at least one of at least one first connection line and at least one second connection line of a plurality of data connection lines; and a light-emitting device layer disposed on the plurality of planarization layers and including a plurality of light-emitting devices corresponding to each of the plurality of emission areas, wherein the optical area includes a first area and a second area, and at least one of the plurality of data sub-lines disposed in the second area may be lines with curves or angular turns.

## Claims

1. A display device (100) comprising:
a display panel (110) including an optical area (OA) having a plurality of transmissive areas (TA) and a plurality of first emission areas (EA1), a general area (NA) disposed outside the optical area (OA) and having a plurality of second emission areas (EA), and a plurality of data connection lines (DCL1, DCL2) disposed in a first direction in at least one of the plurality of transmissive areas (TA); and
an optoelectronic device (11, 12) disposed below the display panel (110) and overlapping the optical area (OA),
wherein the plurality of data connection lines (DCL1, DCL2) includes at least one first connection line (DCL1) disposed in a first area (A1) and a second area (A2) of the optical area (OA), and at least one second connection line (DCL2) disposed in the first area (A1) and having a lower resistance than the at least one first connection line (DCL1).

2. The display device (100) of claim 1, wherein the second area (A2) is an area located at each of a first side and a second side of the first area (A1).

3. The display device (100) of claim 1 or 2, wherein the first area (A1) is divided into an upper area (UA), an intermediate area (CA), and a lower area (LA), and the at least one second connection line (DCL2) is disposed in at least one of the upper area (UA) and the lower area (LA).

4. The display device (100) of claim 3, wherein the at least one first connection line (DCL1) is disposed in the intermediate area (CA), and/or
wherein the at least one first connection line (DCL1) is disposed in at least one of the upper area (UA) and the lower area (LA).

5. The display device (100) of any of claims 1 to 4, wherein at least one of the plurality of data connection lines (DCL1, DCL2) disposed in the first area (A1) and at least one of the plurality of data connection lines (DCL1, DCL2) disposed in the second area (A2) have different wiring widths.

6. The display device (100) of any of claims 1 to 5, wherein at least one of the plurality of data connection lines (DCL1, DCL2) disposed in the first area (A1) has a larger wiring width than at least one of the plurality of data connection lines (DCL1, DCL2) disposed in the second area (A2).

7. The display device (100) of any of claims 1 to 6, wherein at least one of the plurality of data connection lines (DCL1, DCL2) disposed in the first area (A1) and at least one of the plurality of data connection lines (DCL1, DCL2) disposed in the second area (A2) have different wiring lengths.

8. The display device (100) of any of claims 1 to 7, wherein at least one of the plurality of data connection lines (DCL1, DCL2) disposed in the second area (A2) are lines with curves or angular turns.

9. The display device (100) of claim 8, wherein the lines with curves or angular turns include a zigzag pattern.

10. The display device (100) of any of claims 1 to 9, wherein at least one of the plurality of data connection lines (DCL1, DCL2) is disposed between a planarization layer (PLN1, PLN2) and a source-drain electrode pattern (SD1, SD2).

11. The display device (100) of any of claims 1 to 10, whererin at least one of the plurality of data connection lines (DCL1, DCL2) is disposed under a source-drain electrode pattern (SD1, SD2),
wherein, preferably, the at least one of the plurality of data connection lines (DCL1, DCL2) is disposed between a plurality of interlayer insulating films (ILD2, ILD3).

12. The display device (100) of any of claims 1 to 9, wherein the display panel (110) comprises:
a plurality of data sub-lines (DSL) disposed in the first direction in the plurality of first emission areas (EA1) and disposed in a different layer from the at least one first connection line (DCL1); and
at least one connection pattern (CP) electrically connecting at least one of the plurality of data sub-lines (DSL) to a corresponding line among the at least one first connection line (DCL1),
wherein, preferably, the plurality of data sub-lines (DSL) have a lower resistance than the at least one first connection line (DCL1).

13. The display device (100) of any of claims 1 to 12, wherein the at least one first connection line (DCL1) has a high light transmittance.

14. The display device (100) of claim 12, wherein the display panel (110) comprises:
a substrate (SUB);
a transistor layer (TRL) disposed on the substrate (SUB) and including at least one transistor (DRT) and a plurality of interlayer insulating films (ILD1, ILD2, ILD3); and
a plurality of planarization layers (PLN1, PLN2) disposed on the transistor layer (TRL),
wherein the plurality of data sub-lines (DSL) is disposed on any one of the plurality of planarization layers (PLN1, PLN2).

15. The display device (100) of claim 14, wherein the at least one first connection line (DCL1) is disposed on any one of the plurality of interlayer insulating films (ILD1, ILD2, ILD3), and/or
wherein the at least one second connection line (DCL2) is disposed on any one of the plurality of planarization layers (PLN1, PLN2).
